# EUROPEAN PATENT SPECIFICATION

(11) **EP 4 345 544 B1**
(45) Date of publication and mention of the grant of the patent: **04.11.2026**
(21) Application number: 23183213.0
(22) Date of filing: 04.07.2023
(51) Int. Cl.: G05B 13/04, G05B 19/418

(54) **APPARATUS AND METHOD FOR MANUFACTURING DISPLAY DEVICE**
VORRICHTUNG UND VERFAHREN ZUR HERSTELLUNG EINER ANZEIGEVORRICHTUNG
APPAREIL ET PROCÉDÉ DE FABRICATION DE DISPOSITIF D'AFFICHAGE

(30) Priority: 30.09.2022 KR 20220125795
(43) Date of publication of application: 03.04.2024
(73) Proprietor: Samsung Display Co., Ltd., Yongin-si, Gyeonggi-do 17113 (KR)
(72) Inventor: Kim, Yonggu, Giheung-gu, Yongin-si 17113 (KR)
(74) Representative: Dr. Weitzel & Partner

(56) References cited:
- KR-A- 20200 065 151
- US-A1- 2022 121 181

## Description

### BACKGROUND

### 1. Field

Aspects of one or more embodiments relate to an apparatus and a method for manufacturing a display device.

### 2. Description of the Related Art

Mobile electronic apparatuses have become widely used. Recently, tablet personal computers (PCs) have been commonly used as mobile electronic apparatuses, in addition to small electronic apparatuses, such as mobile phones.

Such mobile electronic apparatuses include display devices to support various functions or provide users with visual information, such as images or videos. Recently, as the sizes of elements for driving a display device have been reduced, a ratio of a display device in an electronic apparatus has gradually increased, and a display device with a structure that is foldable to a certain angle from a flat state has been developed.

Reference is made to US 2022/121181 A1.

The above information disclosed in this Background section is only for enhancement of understanding of the background and therefore the information discussed in this Background section does not necessarily constitute prior art.

### SUMMARY

Aspects of one or more embodiments relate to an apparatus and a method for manufacturing a display device.

According to one or more embodiments, a plurality of transport units are controlled such that an operation rate of each of the plurality of transport units is within a designated range.

However, the one or more embodiments described below are only examples, and the scope of embodiments according to the present disclosure is not limited thereto.

Additional aspects will be set forth in part in the description that follows and, in part, will be apparent from the description, or may be learned by practice of the embodiments of the disclosure.

The invention is defined by independent claims 1 and 5. Preferred embodiments are defined by the dependent claims.

Other aspects, features, and characteristics other than those described above will become apparent from the accompanying drawings, the appended claims, and the detailed description of the disclosure.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 is a block diagram schematically illustrating an apparatus for manufacturing a display device, according to some embodiments;
FIG. 2 is a schematic perspective view of an apparatus for manufacturing a display device, according to some embodiments;
FIG. 3 is a diagram schematically illustrating a configuration of a controller according to some embodiments;
FIG. 4 is a flowchart of a method of manufacturing a display device, according to some embodiments;
FIG. 5 is a plan view schematically illustrating a display device according to some embodiments;
FIG. 6 is a cross-sectional view schematically illustrating a display device manufactured by using a method of manufacturing a display device, according to some embodiments;
FIG. 7 is an equivalent circuit diagram of any one pixel of a display panel, according to some embodiments;
FIG. 8 is a schematic perspective view of an apparatus for manufacturing a display device, according to some embodiments;
FIG. 9 is a diagram schematically illustrating a configuration of a controller according to some embodiments;
FIG. 10 is a flowchart of a method for manufacturing a display device, according to some embodiments;
FIG. 11 is a schematic perspective view of an apparatus for manufacturing a display device, according to some embodiments;
FIG. 12 is a diagram schematically illustrating a configuration of a controller according to some embodiments; and
FIG. 13 is a flowchart of a method for manufacturing a display device, according to some embodiments.

### DETAILED DESCRIPTION

Reference will now be made in more detail to aspects of some embodiments, which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or any variations thereof.

As the disclosure allows for various changes and numerous embodiments, certain embodiments will be illustrated in the drawings and described in detail in the written description. Hereinafter, effects and features of the disclosure and a method for accomplishing them will be described more fully with reference to the accompanying drawings, in which embodiments of the disclosure are shown. This disclosure, however, may be embodied in many different forms and should not be construed as limited to the embodiments set forth herein.

One or more embodiments of the disclosure will be described below in more detail with reference to the accompanying drawings. Those elements that are the same or are in correspondence are rendered the same reference numeral regardless of the figure number, and redundant descriptions thereof are omitted.

In embodiments described below, terms such as "first" and "second" are used herein merely to describe a variety of elements, but the elements are not limited by the terms. Such terms are used only for the purpose of distinguishing one element from another element.

In embodiments described below, an expression used in the singular encompasses the expression of the plural, unless it has a clearly different meaning in the context.

In embodiments described below, terms such as "include" or "comprise" may be construed to denote a certain characteristic or element, or a combination thereof, but may not be construed to exclude the existence of or a possibility of addition of one or more other characteristics, elements, or any combinations thereof.

It will be understood that when a layer, region, or element is referred to as being "formed on" another layer, region, or element, it can be directly or indirectly formed on the other layer, region, or element. That is, for example, intervening layers, regions, or elements may be present.

Sizes of elements in the drawings may be exaggerated or reduced for convenience of explanation. In other words, since sizes and thicknesses of elements in the drawings are arbitrarily illustrated for convenience of explanation, the following embodiments are not limited thereto.

In the following embodiments, the x-axis, the y-axis, and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When certain embodiments may be implemented differently, a specific process order may be performed differently from the described order. For example, two consecutively described processes may be performed substantially at the same time or performed in an order opposite to the described order.

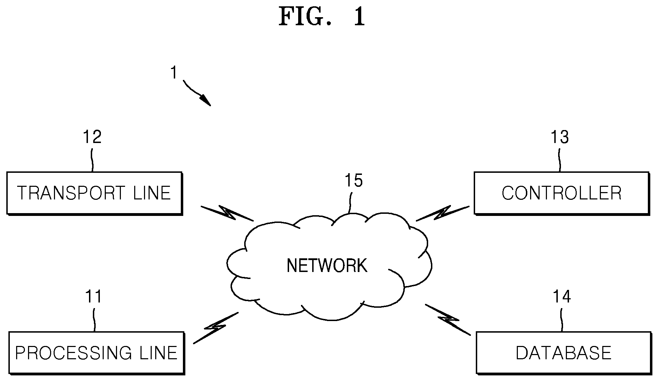

FIG. 1 is a block diagram schematically illustrating an apparatus 1 for manufacturing a display device, according to some embodiments.

Referring to FIG. 1, the apparatus 1 for manufacturing the display device may include a processing line 11, a transport line 12, a controller 13, a database 14, and a network 15.

The processing line 11 includes a plurality of processing units. Transport goods may be taken out of the plurality of processing units or carried into the plurality of processing units. In a state in which the transport goods are carried into the plurality of processing units, a processing process for the transport goods may be performed in the plurality of processing units. When the processing of the transport goods is completed in the plurality of processing units, the transport goods may be taken out of the plurality of processing units.

The transport line 12 includes a plurality of transport units. The plurality of transport units may transport the transport goods and may take in the transport goods to or take the transport goods out of the plurality of processing units.

The controller 13 may control the plurality of transport units. For example, the controller 13 may control movement paths of the plurality of transport units and whether the plurality of transport units are operated.

The database 14 may be a storage device capable of storing various pieces of information necessary for controlling the plurality of transport units. The database 14 may store data about the processing line 11 and the transport line 12.

The database 14 may include at least one independent sub-database that stores information belonging to a specific range, and may include an integrated database in which the at least one independent sub-database is integrated into one. When the database 14 includes the at least one independent sub-database, each sub-database may be wirelessly connected to each other through Bluetooth, Wi-Fi, or the like, and may exchange data with each other through the network 15. When the database 14 includes the integrated database, an additional device for integrating each sub-database into one and managing data exchange and control flow between the sub-databases may be included.

The network 15 may connect the processing line 11, the transport line 12, the controller 13, and the database 14 to one another. The network 15 may include wired network 15 and various wireless networks 15, such as wireless local area network (WLAN; Wi-Fi), single-hop, multi-hop, radio-frequency identification (RFID), or Bluetooth. The network 15 may include a wireless repeater that relays wireless communication. The wireless repeater may form a wireless communication network, and may include various wireless communication technology, such as WLAN, single-hop, multi-hop, or Bluetooth.

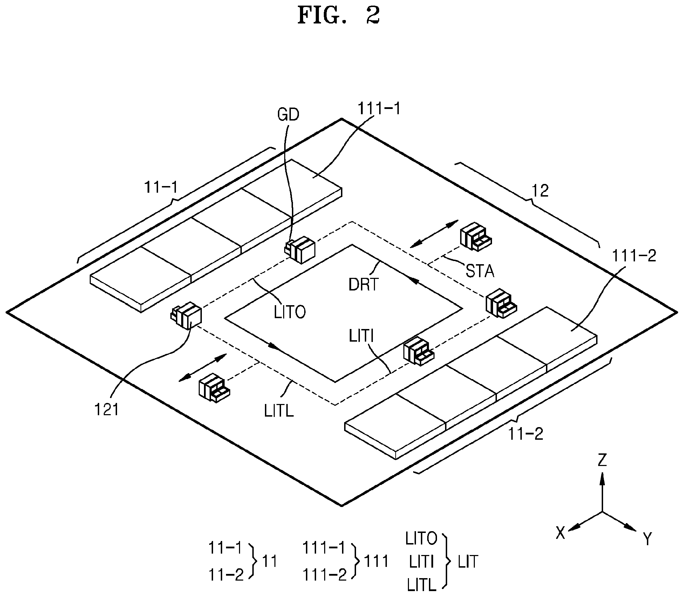

FIG. 2 is a schematic perspective view of an apparatus for manufacturing a display device, according to some embodiments.

The processing line 11 may be provided in a plurality, and each of the plurality of processing lines may include a plurality of processing units (or processors) 111. The plurality of processing units 111, in particular the plurality of the processing lines 11, 11-1, 11-2, may be linearly arranged in a first direction. For example, the first direction may be an X-axis direction. For example, the processing line 11 may include a first processing line 11-1 and a second processing line 11-2.

The first processing line 11-1 may include a plurality of first processing units 111-1. For example, four first processing units 111-1 may be linearly arranged in the first direction. However, this is an example, and the arrangement and number of first processing units 111-1 are not limited thereto.

The second processing line 11-2 may include a plurality of second processing units 111-2. The number of second processing units 111-2 and the number of first processing units 111-1 may be equal to each other. For example, four second processing units 111-2 may be linearly arranged in the first direction. However, this is an example, and the arrangement and number of second processing units 111-2 are not limited thereto.

The first processing line 11-1 and the second processing line 11-2 may be arranged parallel to each other in the first direction. This may mean that the first processing line 11-1 and the second processing line 11-2 may be in parallel to each other, wherein the first processing line 11-1 and the second processing line 11-2 may be each arranged in the first direction X and in parallel to each other in a second direction Y. The first processing line 11-1 and the second processing line 11-2 may be arranged apart from each other in a second direction. The second direction may be a direction crossing the first direction. For example, the first direction may be a X-axis direction and the second direction may be a Y-axis direction.

The transport line 12 including a plurality of transport units 121 is arranged between the plurality of processing lines 11. The plurality of transport units 121 moves between each of the plurality of processing lines 11. The plurality of transport units 121 takes out transport goods GD from any one processing unit 111, transports the taken-out goods GD, and takes in the transported transport goods GD to another processing unit 111.

The transport line 12 may be arranged between the first processing line 11-1 and the second processing line 11-2. Each of the plurality of transport units 121 may move in a transport direction along a transport path LIT. The plurality of transport units 121 may take out the transport goods GD from any one of the first processing units 111-1, and then transport the taken-out transport goods GD along the transport path LIT and take in the transported transport goods GD to any one of the second processing units 111-2. The transport path LIT may describe a square shape, Wherein in particular parts of the transport path LIT may be in parallel to the first processing line 11-1 and the second processing line 11-2 , and parts of the transport path LIT may be orthogonal to the first processing line 11-1 and the second processing line 11-2.

The transport path LIT on which the plurality of transport units 121 transport the transport goods GD may include a take-out path LITO, a take-in path LITI, and a connection path LITC.

The take-out path LITO may be a path for taking out the transport goods GD from the processing units 111. For example, the take-out path LITO may have the first direction that is parallel to the first processing line 11-1, and may be arranged adjacent to the first processing line 11-1. While the plurality of transport units 121 moves in a transport direction DRT along the take-out path LITO, the plurality of transport units 121 may stop adjacent to any one first processing unit 111-1 and then take out the transport goods GD from the first processing unit 111-1.

The take-in path LITI may be a path for taking in the transport goods GD to the processing units 111. For example, the take-in path LITI may have the first direction that is parallel to the second processing line 11-2, and may be arranged adjacent to the second processing line 11-2. While the plurality of transport units 121 moves in the transport direction DRT along the take-in path LITI, the plurality of transport units 121 may stop adjacent to any one second processing unit 111-2 and then take in the transport goods GD to the second processing unit 111-2.

The connection path LITC may connect the take-out path LITO and the take-in path LITI to each other. The connection path LITC may be provided in two. The connection path LITC may have the second direction, and opposite ends of the connection path LITC may be connected to an end of the take-out path LITO and an end of the take-in path LITI, respectively. The plurality of transport units 121 may circulate the take-out path LITO, the connection path LITC, the take-in path LITI, and the connection path LITC toward the transport direction DRT.

In this structure, a planar shape of the transport path LIT may be a quadrangle. In addition, when viewed from above (e.g., in a plan view), the transport direction DRT may be a counterclockwise direction (e.g., a direction rotating around a + Z axis). However, this is an example, and the transport path LIT and the transport direction DRT are not limited thereto.

A stage STA may be arranged at a position adjacent to the transport path LIT. The plurality of transport units 121 may move between the stage STA and the transport path LIT. One or more transport units 121 located in the stage STA may not operate. In other words, the one or more transport units 121 located in the stage STA may maintain a stationary state. The stage STA may be provided in a plurality. For example, two stages STA may be arranged to be connected to the two connection paths LITC, respectively.

The transport unit 121 may sequentially move along the take-out path LITO and the connection path LITC and then move to the stage STA to maintain a stationary state. The transport unit 121 in a stationary state at the stage STA may sequentially move along the connection path LITC and the take-in path LITI again.

On the other hand, the transport unit 121 may sequentially move along the take-in path LITI and the connection path LITC and then move to the stage STA to maintain a stationary state. The transport unit 121 in a stationary state at the stage STA may sequentially move along the connection path LITC and the take-out path LITO again.

When at least one of the plurality of transport units 121 moves between the transport path LIT and the stage STA, a number of transport units 121 moving along the transport path LIT may be adjusted.

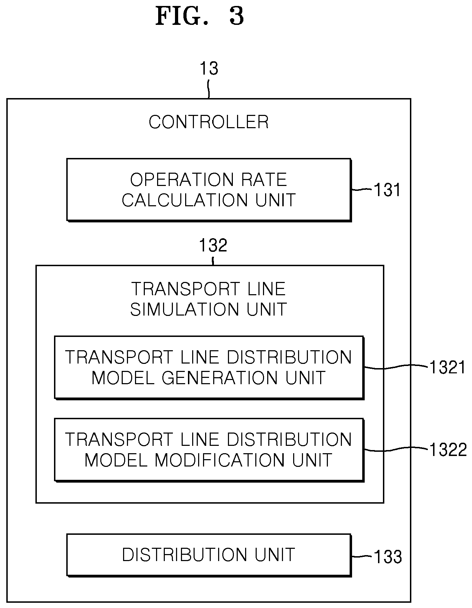

FIG. 3 is a diagram schematically illustrating a configuration of a controller 13 according to some embodiments.

Referring to FIG. 3, the controller 13 includes an operation rate calculation unit (or operation rate calculator) 131, a transport line simulation unit (or transport line simulator) 132, and a distribution unit (or distributor) 133.

The operation rate calculation unit 131 calculates an operation rate of each of the plurality of transport units 121 (see FIG. 2). The "operation rate" may be "time during which the transport unit 121 operates for a designated time/designated time x 100" (%). Here, "the time during which the transport unit 121 operates for a designated time" may be, in the transport line 12, "time during which the transport unit 121 takes out the transport goods GD (see FIG. 2) from the processing unit 111 (see FIG. 2) during the designated time + time during which the transport unit 121 takes in the transport goods GD during the designated time + time during which the transport unit 121 moves during the designated time." The operation rate calculation unit 131 may receive an operation rate of each of the plurality of transport units 121 from the transport line 12 through the network 15 (see FIG. 1). In addition, the controller 13 may store the operation rate of each of the plurality of transport units 121 in the database 14.

When a number of transport units 121 arranged on the transport path LIT (see FIG. 2) is small and the operation rate of the transport unit 121 exceeds a specific range, a transport speed of the transport unit 121 may not keep up with a processing speed of the processing line 11 (see FIG. 2), and thus, efficiency of the transport line 12 (see FIG. 2) may decrease. In addition, when the number of transport units 121 arranged on the transport path LIT is large and the operation rate of the transport unit 121 is less than the specific range, traffic congestion between the plurality of transport units 121 may occur, reducing the efficiency of the transport line 12. When the operation rate of the transport unit 121 is greater than or equal to 65 % and less than or equal to 75 %, the efficiency of the transport line 12 may be high.

The transport line simulation unit 132 may calculate the number of plurality of transport units 121 arranged on the transport path LIT such that the operation rates of the plurality of transport units 121 are within a designated range, and simulate a transport line distribution model for distributing the plurality of transport units 121. For example, the designated range may be greater than or equal to 65% and less than or equal to 75 %.

The transport line distribution model may be a model for distributing the plurality of transport units 121 such that the operation rates of the plurality of transport units 121 are within a designated range, by moving the transport unit 121 arranged in the stage STA (see FIG. 2) to the transport path LIT and increasing the number of transport units 121 arranged on the transport path LIT when an operation rate of at least one of the plurality of transport units 121 exceeds the designated range.

In addition, the transport line distribution model may be a model for distributing the plurality of transport units 121 such that the operation rates of the plurality of transport units 121 are within the designated range, by moving the transport unit 121 on the transport path LIt to the stage STA and reducing the number of transport units 121 arranged on the transport path LIT when the operation rate of at least one of the plurality of transport units 121 is less than the designated range.

The distribution unit 133 may distribute the plurality of transport units 121 according to the transport line distribution model. For example, according to the transport line distribution model, the distribution unit 133 may move the transport unit 121 from the transport path LIT to the stage STA or may move the transport unit 121 from the stage STA to the transport path LIT.

The transport line simulation unit 132 described above may include a transport line distribution model generation unit (or transport line distribution model generator) 1321 and a transport line distribution model modification unit (or transport line distribution model modifier or transport line distribution model modification component or transport line distribution model modification circuit) 1322.

The transport line distribution model generation unit 1321 generates an initial transport line distribution model. Here, the initial transport line distribution model may be an initial model of the transport line distribution model described above. The transport line distribution model generation unit 1321 may generate the initial transport line distribution line by considering a first transport line variable. The first transport line variable may be a variable already stored in the database 14 (see FIG. 1).

The first transport line variable includes an operation plan of the plurality of processing lines 11. The operation plan of the processing line 11 may include at least one of a planned type, processing speed, number, or arrangement of the processing line 11 of the plurality of processing lines 11. When data for the operation plan of the processing line 11 is input to the database 14, the network 15 may transmit the input data to the transport line distribution model generation unit 1321. Accordingly, the transport line distribution model generation unit 1321 may generate the transport line distribution model based on the operation plan of the processing line 11.

For example, the first transport line variable may include at least one of the processing speeds or failures of the plurality of processing units 111 of the plurality of processing lines 11. In a process of processing the transport goods GD of the processing units 111, a processing speed of each of the processing units 111 may continue to change, and a failure may occur in at least one of the plurality of processing units 111. The processing speed and failure of each of the plurality of processing units 111 may be detected in real time, and the network 15 may transmit data for the processing speed and failure of each of the plurality of processing units 111 to the database 14. When the data is input to the database 14, the network 15 may transmit the input data to the transport line distribution model generation unit 1321. Accordingly, the transport line distribution model generation unit 1321 may generate a transport line distribution model based on the processing speed and failure of each of the plurality of processing units 111.

For example, the first transport line variable may include a real-time operation rate of each of the plurality of transport units 121. The network 15 may transmit, to the database 14, data on the operation rate of each of the plurality of transport units 121. When the database 14 is input to the database 14, the network 15 may transmit the input data to the transport line distribution model generation unit 1321. Accordingly, the transport line distribution model generation unit 1321 may generate a transport line distribution model based on the real-time operation rate of each of the plurality of processing units 111. However, this is an example, and the first transport line variable is not limited thereto.

The distribution unit 133 may distribute the plurality of transport units 121 according to an initial transport line distribution model generated by the transport line distribution model generation unit 1321. Thereafter, the operation rate calculation unit 131 may calculate an operation rate of each of the plurality of transport units 121. An operation rate of at least one of the plurality of transport units 121 calculated by the operation rate calculation unit 131 may not be within a designated range.

In this case, the transport line distribution model modification unit 1322 ay modifies the initial transport line distribution model to a first-order modified transport line model by considering a second transport line variable. The second transport line variable may be an unexpected variable in the step of generating the initial transport line distribution model by the transport line distribution model generation unit 1321. The second transport line variable may be a variable not stored in the database 14.

The second transport line variable includes data on a collision between the plurality of transport units 121. When at least two of the plurality of transport units 121 collide, at least one of the plurality of transport units 121 may deviate from the transport path LIT. The network 15 may transmit the data on the collision between the plurality of transport units 121 to the database 14. When the data is input to the database 14, the network 15 may transmit the input data to the transport line distribution model modification unit 1322.

The second transport line variable includes a variable for an unexpected situation occurring in the plurality of processing units 111. The second transport line variable is a variable regarding whether there is a shortage of materials necessary for the processing unit 111 to process the transport goods GD. In addition, the second transport line variable is a variable for unplanned or irregular maintenance or repair of the processing unit 111. The network 15 may transmit, to the database 14, the data on the unexpected situation occurring in the plurality of processing units 111. When the data is input to the database 14, the network 15 may transmit the input data to the transport line distribution model modification unit 1322.

However, this is an example, and the second transport line variable is not limited thereto. For example, the second transport line variable may include a variable related to an operator's intervention in the processing line 11 or the transport line 12. Further, the second transport line variable includes a variable for a communication error between at least one of the processing line 11, the transport line 12, the controller 13, the database 14, or the network 15.

The distribution unit 133 distributes the plurality of transport units 121 according to the first-order modified transport line distribution model that is obtained through modification by the transport line distribution model modification unit 1322. Thereafter, the operation rate calculation unit 131 calculates an operation rate of each of the plurality of transport units 121. An operation rate of at least one of the plurality of transport units 121 calculated by the operation rate calculation unit 131 may not be within a designated range. In this case, the transport line distribution model modification unit 1322 remodifies the first-order modified transport line distribution model to a second-order transport line distribution model.

The distribution unit 133 distributes the plurality of transport units 121 according to the second-order modified transport line distribution model that is obtained through modification by the transport line distribution model modification unit 1322. Thereafter, the operation rate calculation unit 131 may calculate an operation rate of each of the plurality of transport units 121. Until the operation rates of all of the plurality of transport units 121 calculated by the operation rate calculation unit 131 fall within the designated range, the transport line distribution model may be repeatedly remodified according to a same process as the above-described process.

While the transport line distribution model modification unit 1322 repeats modification and remodification of the transport line distribution model, the second transport line variable may be stored in the database 14. The second transport line variable stored in the database 14 may be converted into the first transport line variable. In other words, while the transport line distribution model modification unit 1322 repeats modification and remodification of the transport line distribution model, the first transport line variable may gradually increase, and the transport line distribution model generation unit 1321 may be continuously updated.

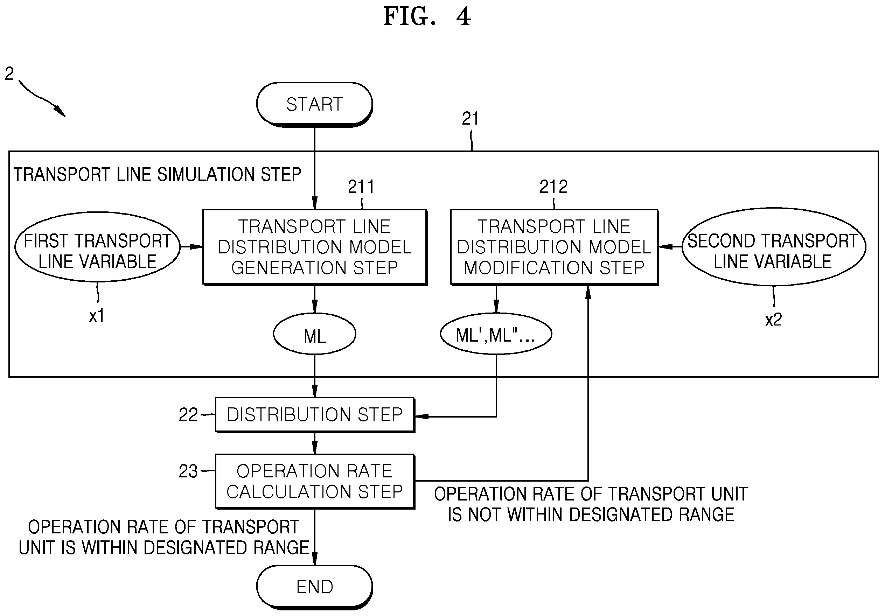

FIG. 4 is a flowchart of a method 2 of manufacturing a display device, according to some embodiments.

Referring to FIG. 4, the method 2 of manufacturing the display device may include a transport line simulation step 21, a distribution step 22, and an operation rate calculation step 23.

The transport line simulation step 21 may be a step of simulating, by the transport line simulation unit 132 (see FIG. 2), a transport line distribution model for distributing the plurality of transport units 121, such that operation rates of the plurality of transport units 121 (see FIG. 2) are within a designated range.

The distribution step 22 may be a step of distributing the plurality of transport units 121 according to the transport line distribution model by the distribution unit 133 (see FIG. 2).

The operation rate calculation step 23 may be a step of calculating an operation rate of each of the plurality of transport units 121 by the operation rate calculation unit 131 (see FIG. 2).

The transport line simulation step 21 described above may include a transport line distribution model generation step 211 and a transport line distribution model modification step 212.

The transport line distribution model generation step 211 may be a step of generating, by the transport line distribution model generation unit 1321 (see FIG. 2), an initial transport line distribution model ML by considering a first transport line variable x1. The distribution step 22 may include a step of distributing, by the distribution unit 133, the plurality of transport units 121 according to the initial transport line distribution model ML generated in the transport line distribution model generation step 211. The operation rate calculation step 23 may include a step of calculating, by the operation rate calculation unit 131, operation rates of the plurality of transport units 121 after the distribution unit 133 distributes the plurality of transport units 121 according to the initial transport line distribution model ML. When all of the operation rates of the plurality of transport units 121 calculated in the operation rate calculation step 23 are within the designated range, the method 2 of manufacturing the display device may be terminated.

The transport line distribution model modification step 212 may include a step of, when the operation rates of the plurality of transport units 121 are not within the designated range, modifying, by the transport line distribution model modification unit 1322 (see FIG. 2), the initial transport line distribution model ML to a first-order modified transport line distribution model ML' by considering a second transport line variable x2. The distribution step 22 may include a step of distributing, by the distribution unit 133, the plurality of transport units 121 according to the first-order modified transport line distribution model ML' generated in the transport line distribution model modification step 212. The operation rate calculation step 23 may include a step of calculating, by the operation rate calculation unit 131, operation rates of the plurality of transport units 121 after the distribution unit 133 distributes the plurality of transport units 121 according to the first-order modified transport line distribution model ML'. When all of the operation rates of the plurality of transport units 121 calculated in the operation rate calculation step 23 are within the designated range, the method 2 of manufacturing the display device may be terminated.

The transport line distribution model modification step 212 may include a step of, when the operation rates of the plurality of transport units 121 are not within the designated range, remodifying, by the transport line distribution model modification unit 1322, the first-order modified transport line distribution model ML' to a second-order modified transport line distribution model ML". The distribution step 22 may include a step of distributing, by the distribution unit 133, the plurality of transport units 121 according to the second-order modified transport line distribution model ML" generated in the transport line distribution model modification step 212. The operation rate calculation step 23 may include a step of calculating, by the operation rate calculation unit 131, operation rates of the plurality of transport units 121 after the distribution unit 133 distributes the plurality of transport units 121 according to the second-order modified transport line distribution model ML". When all of the operation rates of the plurality of transport units 121 calculated in the operation rate calculation step 23 are within the designated range, the method 2 of manufacturing the display device may be terminated.

The transport line distribution model modification step 212 may include, when the operation rates of the plurality of transport units 121 are not within the designated range, remodifying the second-order modified transport line distribution model ML" again by the transport line distribution model modification unit 1322. Until the operation rate of each of the plurality of transport units 121 is within the designated range, the above-described process in the transport line distribution model modification step 212 may be repeated.

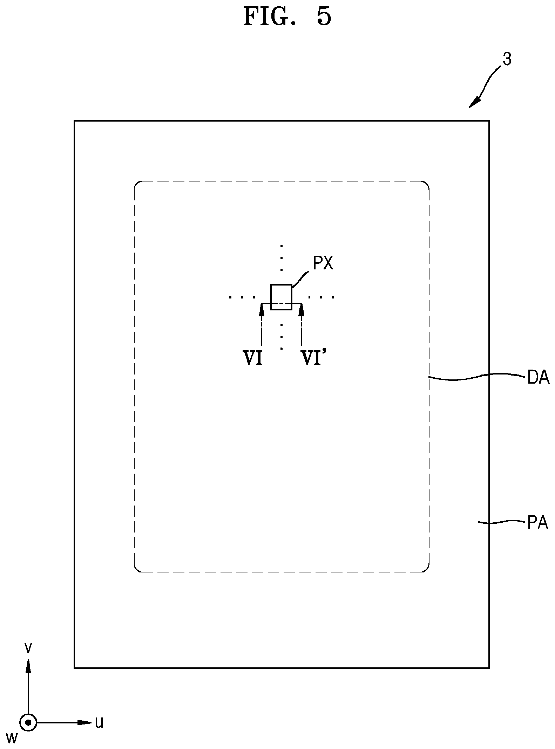

FIG. 5 is a plan view schematically illustrating a display device 3 according to some embodiments.

Referring to FIG. 5, the display device 3 manufactured according to some embodiments may include a display area DA and a peripheral area PA arranged outside the display area DA. The display device 3 may provide an image through an array of a plurality of pixels PX two-dimensionally arranged in the display area DA.

The peripheral area PA is an area in which an image is not provided, and may entirely or partially surround the display area DA. A driver or the like for providing an electrical signal or power to a pixel circuit corresponding to each of the pixels PX may be arranged in the peripheral area PA. A pad, which is an area to which an electronic element or a printed circuit board may be electrically connected, may be arranged in the peripheral area PA.

Hereinafter, it is described that the display device 3 includes an organic light-emitting diode as a light-emitting element. However, the display device 3 of one or more embodiments is not limited thereto. According to some embodiments, the display device 3 may be a light-emitting display device including an inorganic light-emitting diode, that is, an inorganic light-emitting display. The inorganic light-emitting diode may include a PN diode including inorganic semiconductor-based materials. When a forward voltage is applied to the PN junction diode, holes and electrons may be injected, and energy generated by recombination of the holes and electrons may be converted into light energy to emit light of a color. The inorganic light-emitting diode described above may have a width of several to several hundred micrometers, and in some embodiments, the inorganic light-emitting diode may be referred to as a micro light-emitting diode (micro LED). According to some embodiments, the display device 3 may be a quantum dot light-emitting display.

Meanwhile, the display device 3 may be used as a display screen for various products, such as televisions, laptop computers, monitors, billboards, Internet of Things (IoT) devices, as well as portable electronic devices, such as mobile phones, smartphones, tablet personal computers (PC), mobile communication terminals, electronic notebooks, portable multimedia players (PMP), navigations, ultra mobile PCs (UMPC). In addition, the display device 3 according to some embodiments may be used in wearable devices, such as smart watches, watch phones, glasses-type displays, and head-mounted displays (HMD). In addition, the display device 3 according to some embodiments may be used as an instrumental panel of a vehicle, a center information display (CID) arranged on a center fascia or a dashboard of a vehicle, a room mirror display replacing side-view mirrors of a vehicle, and a display screen arranged on a rear surface of a front seat as an entertainment for passengers in the backseat of a vehicle.

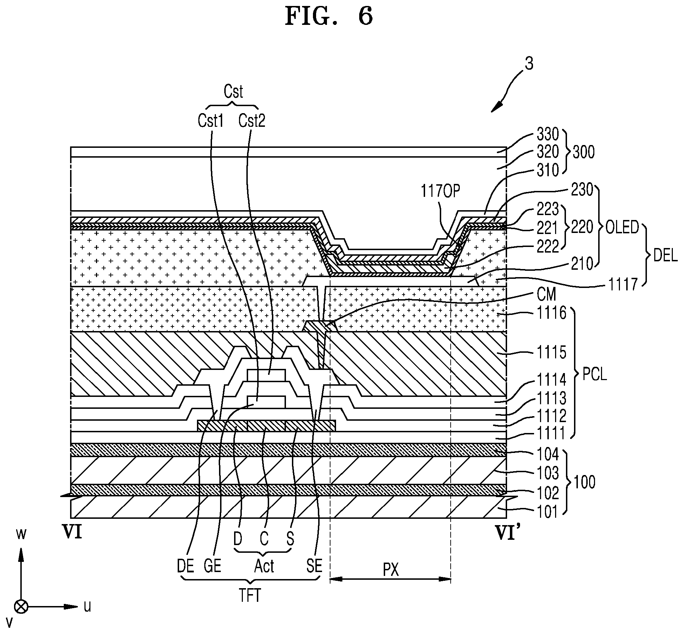

FIG. 6 is a cross-sectional view schematically illustrating the display device 3 manufactured by using a method of manufacturing a display device, taken along line VI-VI' in FIG. 5, according to some embodiments.

Referring to FIG. 6, the display device 3 may include a stacked structure of a substrate 100, a pixel circuit layer PCL, a display element layer DEL, and an encapsulation layer 300.

The substrate 100 may have a multi-layer structure including a base layer and an inorganic layer, the base layer including polymer resin. For example, the substrate 100 may include the base layer including the polymer resin, and a barrier layer that is an inorganic insulating layer. For example, the substrate 100 may include a first base layer 101, a first barrier layer 102, a second base layer 103, and a second barrier layer 104, which are sequentially stacked. Each of the first base layer 101 and the second base layer 103 may include polyimide (PI), polyethersulfone (PES), polyarylate, polyetherimide (PEI), polyethylene naphthalate (PEN), polyethylene terephthalate (PET), polyphenylene sulfide (PPS), polycarbonate, cellulose triacetate (TAC), or/and cellulose acetate propionate (CAP). Each of the first barrier layer 102 and the second barrier layer 104 may include an inorganic insulating material, such as silicon oxide, silicon oxynitride, and/or silicon nitride. The substrate 100 may have a flexible property.

The pixel circuit layer PCL may be located on the substrate 100. In FIG. 6, the pixel circuit layer PCL includes a thin-film transistor TFT, and a buffer layer 1111, a first gate insulating layer 1112, a second gate insulating layer 1113, an interlayer insulating layer 1114, a first planarization insulating layer 1115, and a second planarization insulating layer 1116, which are located under or/and over elements of the thin-film transistor TFT.

The buffer layer 1111 may reduce or block permeation of foreign materials, moisture or ambient air from a lower portion of the substrate 100, and provide a flat surface on the substrate 100. The buffer layer 1111 may include an inorganic insulating material, such as silicon oxide, silicon oxynitride, or silicon nitride, and may have a single-layer or multi-layer structure including the material described above.

The thin-film transistor TFT on the buffer layer 1111 may include a semiconductor layer Act, and the semiconductor layer Act may include polysilicon (poly-Si). Alternatively, the semiconductor layer Act may include amorphous silicon (a-Si), an oxide semiconductor, an inorganic semiconductor, or the like. The semiconductor layer Act may include a channel area C, and a drain area D and a source area S respectively arranged at opposite sides of the channel area C. A gate electrode GE may overlap the channel area C.

The gate electrode GE may include a low-resistance metal material. The gate electrode GE may include a conductive material, including molybdenum (Mo), aluminum (Al), copper (Cu), or titanium (Ti), and may be formed of a single layer or multiple layers including the material described above.

The first gate insulating layer 1112 between the semiconductor layer Act and the gate electrode GE may include an inorganic insulating material, such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ). ZnOₓ may be zinc oxide (ZnO) and/or zinc peroxide (ZnO₂).

The second gate insulating layer 1113 may be provided to cover the gate electrode GE. Similar to the first gate insulating layer 1112, the second gate insulating layer 1113 may include an inorganic insulating material, such as SiO₂, SiNₓ, SiON, Al₂O₃, TiO₂, Ta₂O₅, HfO₂, or ZnOₓ. ZnOₓ may be ZnO and/or ZnO₂.

An upper electrode Cst2 of a storage capacitor Cst may be located on the second gate insulating layer 1113. The upper electrode Cst2 may overlap the gate electrode GE thereunder. In this case, the gate electrode GE and the upper electrode Cst2 overlapping each other with the second gate insulating layer 1113 therebetween may form the storage capacitor Cst. In other words, the gate electrode GE may function as a lower electrode Cst1 of the storage capacitor Cst.

As described above, the storage capacitor Cst and the thin-film transistor TFT may be formed in an overlapping manner. In some embodiments, the storage capacitor Cst may be formed not to overlap the thin-film transistor TFT.

The upper electrode Cst2 may include Al, platinum (Pt), palladium (Pd), silver (Ag), magnesium (Mg), gold (Au), nickel (Ni), neodymium (Nd), iridium (Ir), chrome (Cr), calcium (Ca), Mo, Ti, tungsten (W), and/or Cu, and may include a layer or layers of the materials described above.

The interlayer insulating layer 1114 may cover the upper electrode Cst2. The interlayer insulating layer 1114 may include SiO₂, SiNₓ, SiON, Al₂O₃, TiO₂, Ta₂O₅, HfO₂, or ZnOₓ. ZnOₓ may be ZnO and/or ZnO₂. The interlayer insulating layer 1114 may include a layer or layers including the inorganic insulating materials described above.

Each of a drain electrode DE and a source electrode SE may be located on the interlayer insulating layer 1114. The drain electrode DE and the source electrode SE may be respectively connected to the drain area D and the source area S through contact holes defined in the insulating layers thereunder. Each of the drain electrode DE and the source electrode SE may include a material having good conductivity. Each of the drain electrode DE and the source electrode SE may include a conductive material, including Mo, Al, Cu, or Ti, and may be formed of a layer or layers including the material described above. According to some embodiments, each of the drain electrode DE and the source electrode SE may have a multi-layer structure of a Ti layer, an Al layer, and another Ti layer.

The first planarization insulating layer 1115 may cover the drain electrode DE and the source electrode SE. The first planarization insulating layer 1115 may include an organic insulating material, such as a general-purpose polymer, such as poly(methyl methacrylate) (PMMA) or polystyrene (PS), polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, or any blends thereof.

The second planarization insulating layer 1116 may be located on the first planarization insulating layer 1115. The second planarization insulating layer 1116 may include a same material as the first planarization insulating layer 1115, and may include an organic insulating material, such as PMMA or PS, polymer derivatives having a phenol-based group, an acryl-based polymer, an imide-based polymer, an aryl ether-based polymer, an amide-based polymer, a fluorine-based polymer, a p-xylene-based polymer, a vinyl alcohol-based polymer, and any blends thereof.

The display element layer DEL may be located on the pixel circuit layer PCL having the structure described above. The display element layer DEL may include an organic light-emitting diode OLED as a display element (that is, a light-emitting element), and the organic light-emitting diode OLED may include a stacked structure of a pixel electrode 210, an intermediate layer 220, and a common electrode 230. For example, the organic light-emitting diode OLED may emit one of red, green, and blue light, or may emit one of red, green, blue, and white light. The organic light-emitting diode OLED may emit light through an emission area, and the emission area may be defined as the pixel PX.

The pixel electrode 210 of the organic light-emitting diode OLED may be electrically connected to the thin-film transistor TFT through contact holes defined in the second planarization insulating layer 1116 and the first planarization insulating layer 1115, and a contact metal CM located on the first planarization insulating layer 1115.

The pixel electrode 210 may include a conductive oxide, such as indium tin oxide (ITO), indium zinc oxide (IZO), ZnO, indium oxide (In₂O₃), indium gallium oxide (IGO), or aluminum zinc oxide (AZO). According to some embodiments, the pixel electrode 210 may include a reflective layer including Ag, Mg, Al, Pt, Pd, Au, Ni, Nd, Ir, Cr, or any compounds thereof. According to some embodiments, the pixel electrode 210 may further include a layer including ITO, IZO, ZnO, In₂O₃, on/under the reflective layer described above.

A bank layer 1117 having an opening 117OP exposing a central portion of the pixel electrode 210 may be located on the pixel electrode 210. The bank layer 1117 may include an organic insulating material and/or an inorganic insulating material. The opening 117OP may define an emission area of light emitted by the organic light-emitting diode OLED. For example, a size/width of the opening 117OP may correspond to a size/width of the emission area. Accordingly, a size and/or width of the pixel PX may depend on the size and/or width of the corresponding opening 117OP of the bank layer 1117.

The intermediate layer 220 may include an emission layer 222 formed to correspond to the pixel electrode 210. The emission layer 222 may include a polymer or low-molecular weight organic material emitting light of a color. Alternatively, the emission layer 222 may include an inorganic light-emitting material or quantum dots.

According to some embodiments, the intermediate layer 220 may include a first functional layer 221 and a second functional layer 223, which are respectively located under and on the emission layer 222. For example, the first functional layer 221 may include a hole transport layer (HTL), or may include an HTL and a hole injection layer (HIL). The second functional layer 223, which is an element located on the emission layer 222, may include an electron transport layer (ETL) and/or an electron injection layer (EIL). Similar to the common electrode 230 to be described below, the first functional layer 221 and/or the second functional layer 223 may be common layers formed to entirely cover the substrate 100.

The common electrode 230 may be arranged over the pixel electrode 210 and overlap the pixel electrode 210. The common electrode 230 may include a conductive material having a low work function. For example, the common electrode 230 may include a (semi-)transparent layer including Ag, Mg, Al, Pt, Pd, Au, Ni, Nd, Ir, Cr, lithium (Li), Ca, or any alloys thereof. Alternatively, the common electrode 230 may further include a layer including ITO, IZO, ZnO, or In₂O₃, on the (semi-)transparent layer including the materials described above. The common electrode 230 may be integrally provided as a single body so as to entirely cover the substrate 100.

The encapsulation layer 300 may be located on the display element layer DEL and cover the display element layer DEL. The encapsulation layer 300 may include at least one inorganic encapsulation layer and at least one organic encapsulation layer, and according to some embodiments, FIG. 6 shows that the encapsulation layer 300 includes a first inorganic encapsulation layer 310, an organic encapsulation layer 320, and a second inorganic encapsulation layer 330 that are sequentially stacked.

Each of the first inorganic encapsulation layer 310 and the second inorganic encapsulation layer 330 may include one or more materials from among Al₂O₃, TiO₂, Ta₂O₅, HfO₂, ZnOₓ, SiO₂, SiNₓ, and SiON. The organic encapsulation layer 320 may include a polymer-based material. The polymer-based material may include an acryl-based resin, an epoxy-based resin, PI, polyethylene, etc. According to some embodiments, the organic encapsulation layer 320 may include acrylate. The organic encapsulation layer 320 may be formed by curing a monomer or coating a polymer. The organic encapsulation layer 320 may have transparency.

According to some embodiments, a touch sensor layer may be located on the encapsulation layer 300, and an optical functional layer may be located on the touch sensor layer. The touch sensor layer may obtain coordinate information according to, for example, a touch event. The optical functional layer may reduce reflectivity of light (external light) incident toward the display device from the outside, and/or improve color purity of light emitted from the display device. According to some embodiments, the optical functional layer may include a retarder and/or a polarizer. The retarder may be of a film type or a liquid crystal coating type and may include a λ/2 retarder and/or a λ/4 retarder. The polarizer may include a film-type polarizer or a liquid crystal-type polarizer. The film-type polarizer may include a stretchable synthetic resin film, and the liquid crystal coating-type polarizer may include liquid crystals arranged in a certain array. Each of the retarder and the polarizer may include a protective film.

An adhesive member may be arranged between the touch electrode layer and the optical functional layer. As the adhesive member, general ones known in the art may be employed without limitation. The adhesive member may be a pressure sensitive adhesive (PSA).

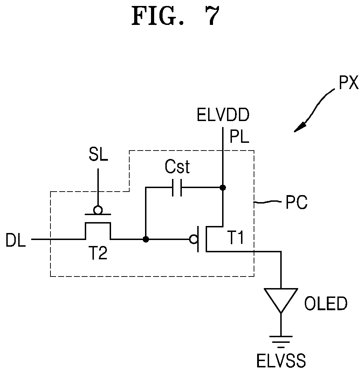

FIG. 7 is an equivalent circuit diagram of any one pixel PX of a display panel according to some embodiments.

Each pixel PX may include a pixel circuit PC and a display element connected to the pixel circuit PC, for example, an organic light-emitting diode OLED. The pixel circuit PC may include a first thin-film transistor T1, a second thin-film transistor T2, and a storage capacitor Cst. Each pixel PX may emit, for example, red, green, blue, or white light through the organic light-emitting diode OLED.

The second thin-film transistor T2, which is a switching thin-film transistor, may be connected to a scan line SL and a data line DL and transfer a data voltage received via the data line DL to the first thin-film transistor T1 based on a switching voltage received via the scan line SL. The storage capacitor Cst may be connected to the second thin-film transistor T2 and a driving voltage line PL and store a voltage corresponding to a difference between a voltage received from the second thin-film transistor T2 and a first power voltage ELVDD supplied via the driving voltage line PL.

The first thin-film transistor T1, which is a driving thin-film transistor, may be connected to the driving voltage line PL and the storage capacitor Cst and control a driving current flowing through the organic light-emitting diode OLED from the driving voltage line PL, the driving current corresponding to the voltage value stored in the storage capacitor Cst. The organic light-emitting diode OLED may emit light having a certain luminance according to the driving current. An opposite electrode (e.g., a cathode) of the organic light-emitting diode OLED may receive a second power voltage ELVSS.

In FIG. 7, the pixel circuit PC includes two thin-film transistors and one storage capacitor. However, embodiments according to the present disclosure are not limited thereto. A number of thin-film transistors and a number of storage capacitors may be variously modified according to a design of the pixel circuit PC. For example, the pixel circuit PC may further include four, five, or more thin-film transistors in addition to the two thin-film transistors described above.

The transport goods GD described with reference to FIGS. 1 to 4 may include the display device 3 described with reference to FIGS. 5 to 7. For example, the transport goods GD described with reference to FIGS. 1 to 4 may include at least one of the substrate 100, the pixel circuit layer PCL, the display element layer DEL, or the encapsulation layer 300 described with reference to FIGS. 5 to 7.

The plurality of processing units 111 described with reference to FIGS. 1 to 4 may be devices that perform a process for manufacturing the display device 3 described with reference to FIGS. 5 to 7. The first processing units 111-1 and the second processing units 111-2 may arrange, on the substrate 100, at least one of the pixel circuit layer PCL, the display element layer DEL, or the encapsulation layer 300. For example, the first processing units 111-1 may arrange the pixel circuit layer PCL on the substrate 100, and the second processing units 111-2 may arrange the display element layer DEL on the pixel circuit layer PCL.

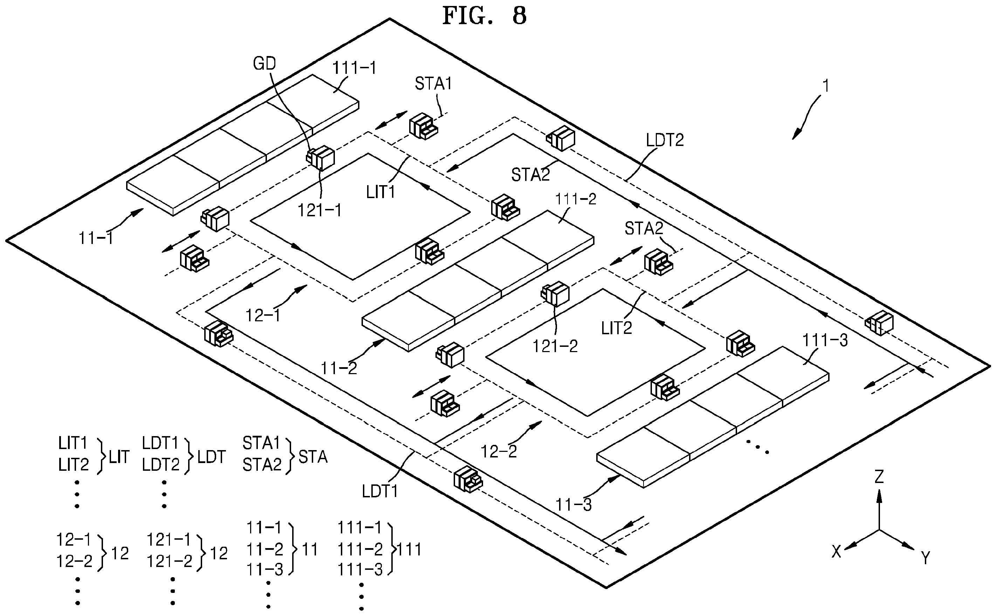

FIG. 8 is a schematic perspective view of an apparatus 1 for manufacturing a display device, according to some embodiments. In FIG. 8, the same reference symbols as those of FIG. 2 denote the same member, and redundant descriptions thereof are omitted.

Compared to the embodiments described with reference to FIGS. 1 to 7, the apparatus 1 for manufacturing the display device of FIG. 8 may include a plurality of transport lines 12. For example, compared to the embodiments described with reference to FIGS. 1 to 7, the plurality of processing lines 11 may further include a third processing line 11-3, and the plurality of transport lines 12 may include a first transport line 12-1 and a second transport line 12-2.

The third processing line 11-3 may include a plurality of third processing units 111-3. For example, four third processing units 111-3 may be linearly arranged in a first direction. For example, the first direction may be an X-axis direction. However, this is an example, and the arrangement and number of third processing units 111-3 are not limited thereto.

The first processing line 11-1, the second processing line 11-2, and the third processing line 11-3 may be arranged parallel to each other in the first direction. The first processing line 11-1, the second processing line 11-2, and the third processing line 11-3 may be arranged apart from each other in a second direction. For example, the second direction may be a Y-axis direction.

The first transport line 12-1 may include a plurality of first transport units 121-1 and may be arranged between the first processing line 11-1 and the second processing line 11-2. The first transport units 121-1 may move along a first transport path LIT1. The first transport unit 121-1 may take out the transport goods GD from any one of the plurality of first processing units 111-1 of the first processing line 11-1, move along the first processing line 11-1 to take in the transport goods GD to any one of the plurality of second processing units 111-2 of the second processing line 11-2, and move along the first transport path LIT1 again to take out the transport goods GD from any one of the plurality of first processing units 111-1 of the first processing line 11-1.

The second transport line 12-2 may include a plurality of second transport units 121-2 and may be arranged between the second processing line 11-2 and the third processing line 11-3. The second transport units 121-2 may move along a second transport path LIT2. The second transport unit 121-2 may take out the transport goods GD from any one of the plurality of second processing units 111-2 of the second processing line 11-2, move along the second transport path LIT2 to take in the transport goods GD to any one of the plurality of third processing units 111-3 of the third processing line 11-3, and move along the second transport path LIT2 again to take out the transport goods GD from any one of the plurality of second processing units 111-2 of the second processing line 11-2.

The stage STA may include a first stage STA1 and a second stage STA2. The first stage STA1 may be arranged at a location adjacent to the first transport path LIT1. The plurality of first transport units 121-1 may move between the first stage STA1 and the first transport path LIT1. In addition, the second stage STA2 may be arranged at a location adjacent to the second transport path LIT2. The plurality of second transport units 121-2 may move between the second stage STA2 and the second transport path LIT2.

A distribution path LDT connecting between a plurality of transport paths LIT may be arranged. The plurality of transport units 121 may move between the plurality of transport paths LIT along the distribution path LDT. When the plurality of transport units 121 move along the distribution path LDT, the plurality of transport units 121 may be distributed to the plurality of transport paths LIT. In other words, a number of plurality of transport units 121 arranged on the plurality of transport paths LIT may be adjusted.

For example, the distribution path LDT may include a first distribution path LDT1 and a second distribution path LDT2, which connect between the first transport path LIT1 and the second transport path LIT2. The first transport units 121-1 may move along the first distribution path LDT1 from the first transport path LIT1. In this process, a number of first transport units 121-1 arranged on the first transport path LIT1 may decrease. At least one of the transport units 121 may move to the first transport path LIT1 along the second distribution path LDT2. In this process, the number of first transport units 121-1 arranged on the first transport path LIT1 may increase.

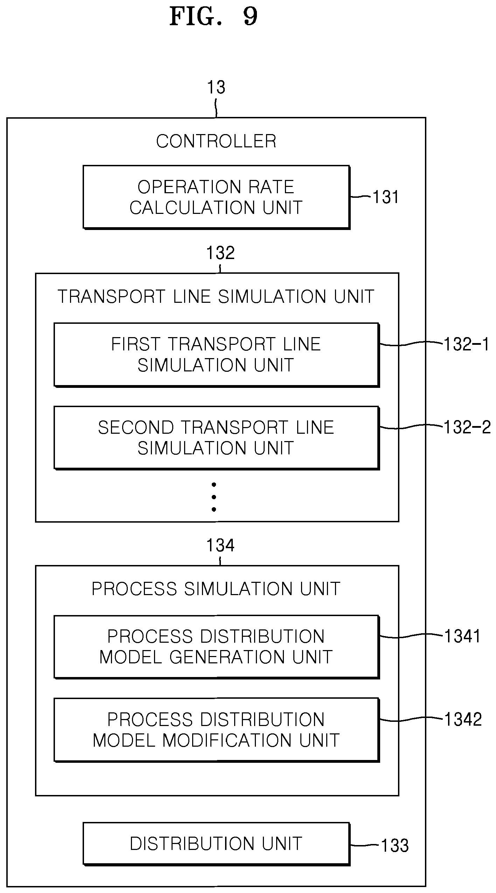

FIG. 9 is a diagram schematically illustrating a configuration of a controller 13 according to some embodiments. In FIG. 9, the same reference symbols as those of FIG. 3 denote the same member, and redundant descriptions thereof are omitted.

Compared to the embodiments described with reference to FIGS. 1 to 7, the controller 13 of FIG. 9 may further include a process simulation unit (or process simulator) 134, and the transport line simulation unit 132 may be provided in a plurality. For example, the transport line simulation unit 132 may include a first transport line simulation unit 132-1 and a second transport line simulation unit 132-2.

The first transport line simulation unit 132-1 may simulate a first-order transport line distribution model for distributing the plurality of first transport units 121-1 by calculating the number of plurality of first transport units 121-1 arranged on the first transport path LIT1 such that operation rates of the plurality of first transport units 121-1 are within a designated range. The second transport line simulation unit 132-2 may simulate a second transport line distribution model for distributing the plurality of second transport units 121-2 by calculating a number of plurality of second transport units 121-2 arranged on the second transport path LIT2 such that operation rates of the plurality of second transport units 121-2 are within a designated range.

The process simulation unit 134 may simulate a process distribution model for distributing the plurality of transport units 121 between the plurality of transport lines 12 based on the transport line distribution model of each of the plurality of transport lines 12. For example, the process distribution model may simulate the plurality of transport units 121 based on the distribution model of the first transport line 12-1 and the distribution model of the second transport line 12-2, such that, when the number of plurality of first transport units 121-1 of the first transport line 12-1 is insufficient and the number of plurality of second transport units 121-2 of the second transport line 12-2 is surplus, the second transport unit 121-2 arranged on the second transport path LIT2 is moved to the first transport path LIT1 along the second distribution path LDT2 so as to change the second transport unit 121-2 to the first transport unit 121-1. The process simulation unit 134 may include a process distribution model generation unit 1341 and a process distribution model modification unit 1342.

The process distribution model generation unit 1341 may generate an initial process distribution model. Here, the initial process distribution model may be an initial model of the process distribution model described above. The process distribution model generation unit 1341 may generate the initial process distribution model by considering a first process variable. The first process variable may be a variable already stored in a database.

The first process variable may include the first transport line variable x1 (see FIG. 4). For example, the first process variable may include at least one of an operation plan of the processing line 11, processing speeds and failures of the plurality of processing units 111 of the plurality of processing lines 11, or a real-time operation rate of each of the plurality of transport units 121.

The distribution unit may distribute the plurality of transport units 121 according to the initial process distribution model generated by the process distribution model generation unit 1341. Thereafter, the operation rate calculation unit 131 may calculate an operation rate of each of the plurality of transport units 121. An operation rate of at least one of the plurality of transport units 121 calculated by the operation rate calculation unit 131 may not be within a designated range. In this case, the process distribution model modification unit 1342 may modify the initial process distribution model to a first-order modified process distribution model.

The process distribution model modification unit 1342 may modify the initial process distribution model to the first-order modified process model by considering a second process variable. The second process variable may be an unexpected variable in the step of generating the initial process distribution model by the process distribution model generation unit 1341. The second process variable may be a variable not stored in the database.

The second process variable may include the second transport line variable x2 (see FIG. 4). For example, the second process variable may include at least one of data on a collision between the plurality of transport units 121, a variable for an unexpected situation occurring in the plurality of processing units 111, a variable regarding whether there is a shortage of materials necessary for the processing unit 111 to process the transport goods GD, a variable for unplanned or irregular maintenance or repair of the processing unit 111, or a variable related to an operator's intervention in the processing line 11 or the transport line 12. In addition, the second process variable may include a variable for a communication error between at least one of the processing line 11, the transport line 12, the controller 13, or the database and the network 15.

The distribution unit may distribute the plurality of transport units 121 according to the first-order modified process distribution model modified by the process distribution model modification unit 1342. Thereafter, the operation rate calculation unit 131 may calculate an operation rate of each of the plurality of transport units 121. An operation rate of at least one of the plurality of transport units 121 calculated by the operation rate calculation unit 131 may not be within the designated range. In this case, the process distribution model modification unit 1342 may remodify the first-order modified process distribution model to a second-order modified process distribution model.

The distribution unit may distribute the plurality of transport units 121 according to the second-order modified process distribution model that is obtained through modification by the process distribution model modification unit 1342. Thereafter, the operation rate calculation unit 131 may calculate an operation rate of each of the plurality of transport units 121. Until the operation rates of all of the plurality of transport units 121 calculated by the operation rate calculation unit 131 fall within the designated range, the process distribution model may be repeatedly remodified according to a same process as the above-described process.

While the process distribution model modification unit 1342 repeats modification and remodification of the process distribution model, the second process variable may be stored in the database. The second process variable stored in the database may be changed to the first process variable. In other words, while the process distribution model modification unit 1342 repeats modification and remodification of the process distribution model, the first process variable may gradually increase, and the process distribution model generation unit 1341 may be continuously updated.

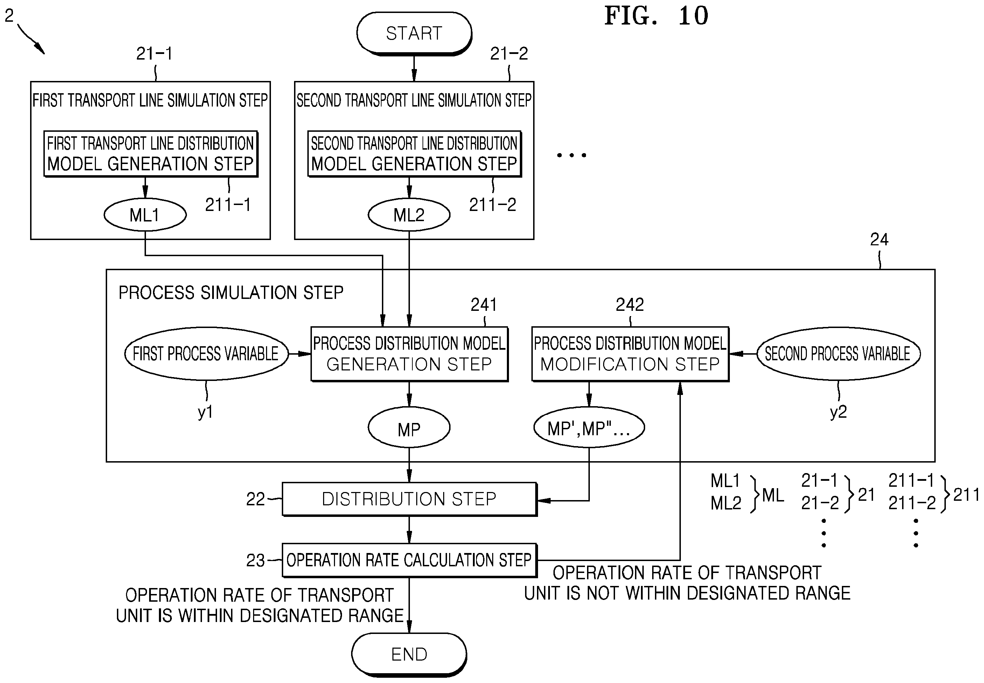

FIG. 10 is a flowchart of a method 2 for manufacturing a display device, according to some embodiments. In FIG. 10, the same reference symbols as those of FIG. 4 denote the same member, and redundant descriptions thereof are omitted.

Compared to the embodiments described with reference to FIGS. 1 to 7, the controller 13 of FIG. 10 may further include a process simulation step 24, and the transport line simulation step 21 may be provided in a plurality. For example, the transport line simulation step 21 may include a first transport line simulation step 21-1 and a second transport line simulation step 21-2.

The first transport line simulation step 21-1 may be a step of simulating, by the first transport line simulation unit 132-1, a first transport line distribution model for distributing the plurality of first transport units 121-1, such that operation rates of the first transport units 121-1 are within a designated range. The first transport line simulation step 21-1 may include a first transport line distribution model generation step 211-1 for generating an initial first transport line distribution model ML1.

The second transport line simulation step 21-2 may be a step of simulating, by the second transport line simulation unit 132-2, a second transport line distribution model for distributing the plurality of second transport units 121-2, such that operation rates of the second transport units 121-2 are within a designated range. The second transport line simulation step 21-2 may include a second transport line distribution model generation step 211-2 for generating an initial second transport line distribution model ML2.

The process simulation step 24 may be a step of simulating, by the process simulation unit 134, a process distribution model for distributing the plurality of transport units 121 between the plurality of transport lines 12. The process simulation step 24 may include a step of simulating the process distribution model for distributing the plurality of transport units 121 between the plurality of transport lines 12 based on the transport line distribution model of each of the plurality of transport lines 12. The process simulation step 24 may include a step of simulating the process distribution model for distributing the plurality of transport units 121 between the plurality of transport lines 12 based on the initial transport line distribution model ML of each of the plurality of transport lines 12. For example, the process simulation step 24 may include a step of simulating the process distribution model for distributing the plurality of transport units 121 between the first transport line 12-1 and the second transport line 12-2 based on the initial first transport line distribution model ML1 and the initial second transport line distribution model ML2.

The process simulation step 24 may include a process distribution model generation step 241 and a process distribution model modification step 242.

The process distribution model generation step 241 may be a step of generating, by the process distribution model generation unit 1341, an initial process distribution model MP by considering a first process variable y1. The distribution step 22 may include a step of distributing, by the distribution unit, the plurality of transport units 121 according to the initial process distribution model MP generated in the process distribution model generation step 241. The operation rate calculation step 23 may include a step of calculating, by the operation rate calculation unit 131, operation rates of the plurality of transport units 121 after the distribution unit distributes the plurality of transport units 121 according to the initial process distribution model MP. When all of the operation rates of the plurality of transport units 121 calculated in the operation rate calculation step 23 are within the designated range, the method 2 of manufacturing the display device may be terminated.

The process distribution model modification step 242 may include a step of, when the operation rates of the plurality of transport units 121 are not within the designated range, modifying, by the process distribution model modification unit 1342, the initial process distribution model MP to a first-order modified process distribution model MP' by considering a second process variable y2. The distribution step 22 may include a step of distributing, by the distribution unit, the plurality of transport units 121 according to the first-order modified process distribution model MP' generated in the process distribution model modification step 242. The operation rate calculation step 23 may include a step of calculating, by the operation rate calculation unit 131, operation rates of the plurality of transport units 121 after the distribution unit distributes the plurality of transport units 121 according to the first-order modified process distribution model MP'. When all of the operation rates of the plurality of transport units 121 calculated in the operation rate calculation step 23 are within the designated range, the method 2 of manufacturing the display device may be terminated.

The process distribution model modification step 242 may include a step of, when the operation rates of the plurality of transport units 121 are not within the designated range, remodifying, by the process distribution model modification unit 1342, the first-order modified process distribution model MP' to a second-order modified process distribution model MP". The distribution step 22 may include a step of distributing, by the distribution unit, the plurality of transport units 121 according to the second-order modified process distribution model MP" generated in the process distribution model modification step 242. The operation rate calculation step 23 may include a step of calculating, by the operation rate calculation unit 131, operation rates of the plurality of transport units 121 after the distribution unit distributes the plurality of transport units 121 according to the second-order modified process distribution model MP". When all of the operation rates of the plurality of transport units 121 calculated in the operation rate calculation step 23 are within the designated range, the method 2 of manufacturing the display device may be terminated.

The process distribution model modification step 242 may include, when the operation rates of the plurality of transport units 121 are not within the designated range, remodifying the second-order modified process distribution model MP" again by the process distribution model modification unit 1342. Until the operation rate of each of the plurality of transport units 121 is within the designated range, the above-described process in the the process distribution model modification step 242 may be repeated.

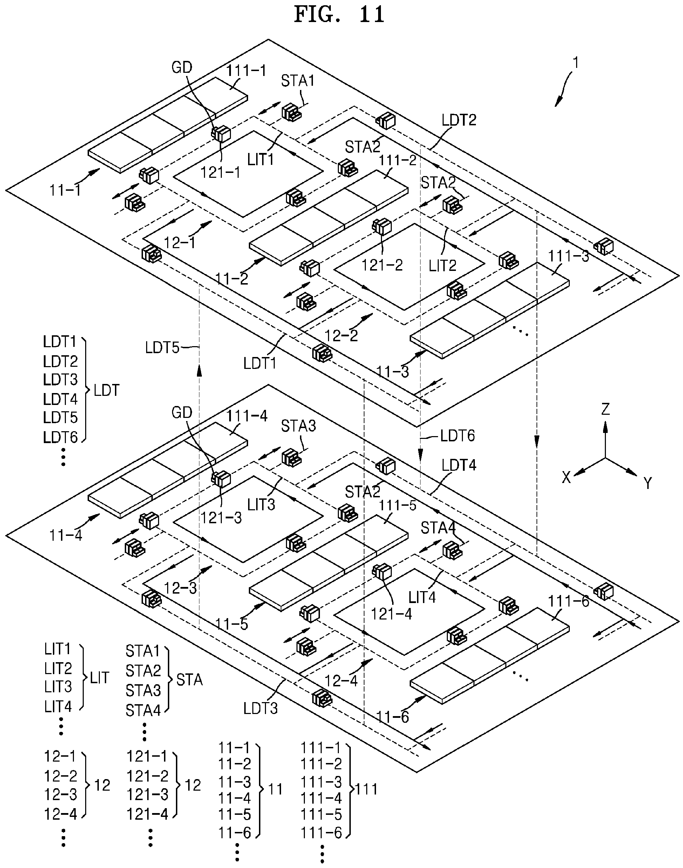

FIG. 11 is a schematic perspective view of an apparatus 1 for manufacturing a display device, according to some embodiments. In FIG. 11, the same reference symbols as those of FIG. 8 denote the same member, and redundant descriptions thereof are omitted.

Compared to the embodiments described with reference to FIGS. 8 to 10, in the embodiments shown in FIG. 11, at least two of the plurality of transport lines 12 may be located on different layers from each other. For example, compared to the embodiments described with reference to FIGS. 8 to 10, the plurality of processing lines 11 may include a fourth processing line 11-4, a fifth processing line 11-5, and a sixth processing line 11-6 on a layer different from a layer on which the first processing line 11-1, the second processing line 11-2, and the third processing line 11-3 are located, and the plurality of transport lines 12 may include a third transport line 12-3 and a fourth transport line 12-4 on a layer different from a layer on which the first transport line 12-1 and the second transport line 12-2 are located.

The fourth processing line 11-4 may include a plurality of fourth processing units 111-4. For example, four fourth processing units 111-4 may be linearly arranged in a first direction. For example, the first direction may be an X-axis direction. However, this is an example, and the arrangement and number of fourth processing units 111-4 are not limited thereto.

The fifth processing line 11-5 may include a plurality of fifth processing units 111-5. For example, four fifth processing units 111-5 may be linearly arranged in a first direction. For example, the first direction may be an X-axis direction. However, this is an example, and the arrangement and number of fifth processing units 111-5 are not limited thereto.

The sixth processing line 11-6 may include a plurality of sixth processing units 111-6. For example, four sixth processing units 111-6 may be linearly arranged in a first direction. For example, the first direction may be an X-axis direction. However, this is an example, and the arrangement and number of sixth processing units 111-6 are not limited thereto.

The fourth processing line 11-4, the fifth processing line 11-5, and the sixth processing line 11-6 may be arranged parallel to each other in the first direction. The fourth processing line 11-4, the fifth processing line 11-5, and the sixth processing line 11-6 may be arranged apart from each other in a second direction. For example, the second direction may be a Y-axis direction.

The third transport line 12-3 may include a plurality of third transport units 121-3 and may be arranged between the fourth processing line 11-4 and the fifth processing line 11-5. The third transport units 121-3 may move along a third transport path LIT3. The third transport unit 121-3 may take out the transport goods GD from any one of the plurality of fourth processing units 111-4 of the fourth processing line 11-4, move along the third transport path LIT3 to take in the transport goods GD to any one of the plurality of fifth processing units 111-5 of the fifth processing line 11-5, and move along the third transport path LIT3 again to take out the transport goods GD from any one of the plurality of fourth processing units 111-4 of the fourth processing line 11-4.

The fourth transport line 12-4 may include a plurality of fourth transport units 121-4 and may be arranged between the fifth processing line 11-5 and the sixth processing line 11-6. The fourth transport units 121-4 may move along a fourth transport path LIT4. The fourth transport units 121-4 may take out the transport goods GD from any one of the plurality of fifth processing units 111-5 of the fifth processing line 11-5, move along the fourth transport path LIT4 to take in the transport goods GD to any one of the plurality of sixth processing units 111-6 of the sixth processing line 11-6, and move along the fourth transport path LIT4 again to take out the transport goods GD from any one of the plurality of fifth processing units 111-5 of the fifth processing line 11-5.

Compared to the embodiments described with reference to FIGS. 8 to 10, in the embodiments shown in FIG. 11, the stage STA may further include a third stage STA3 and a fourth stage STA4. The third transport path LIT3 may be arranged at a location adjacent to the third transport path LIT3. The plurality of third transport units 121-3 may move between the third stage STA3 and the third transport path LIT3. In addition, the fourth stage STA4 may be arranged at a location adjacent to the fourth transport path LIT4. The plurality of fourth transport units 121-4 may move between the fourth stage STA4 and the fourth transport path LIT4.

Compared to the embodiments described with reference to FIGS. 8 to 10, in the embodiments shown in FIG. 11, the distribution path LDT may further include a third distribution path LDT3, a fourth distribution path LDT4, a fifth distribution path LDT5, and a sixth distribution path LDT6.

The third distribution path LDT3 and the fourth distribution path LDT4 may connect between the third transport path LIT3 and the fourth transport path LIT4. The third transport units 121-3 may move along the third distribution path LDT3 from the third transport path LIT3. In this process, a number of third transport units 121-3 arranged on the third transport path LIT3 may decrease. The transport unit 121 may move along the fourth distribution path LDT4 and move to the third transport path LIT3. In this process, the number of third transport units 121-3 arranged on the third transport path LIT3 may increase.

The fifth distribution path LDT5 and the sixth distribution path LDT6 may connect the distribution paths LDT located on different layers from each other. For example, the fifth distribution path LDT5 may connect the first distribution path LDT1 and the third distribution path LDT3, and the sixth distribution path LDT6 may connect between the second distribution path LDT2 and the fourth distribution path LDT4.

According to some embodiments, an additional elevator may be arranged to connect different layers. For example, the elevator may be arranged along the fifth distribution path LDT5 and the sixth distribution path LDT6. Accordingly, at least one of the plurality of transport units 121 may move between the plurality of transport lines 12 through the elevator, the plurality of transport lines 12 being located on different layers from each other.

For example, the third transport unit 121-3 may sequentially move from the third transport path LIT3 along the third distribution path LDT3, the fifth distribution path LDT5, and the first distribution path LDT1. In this process, the third transport unit 121-3 may move from the transport line 12 located on a lower layer to the transport line 12 located on a higher layer. For example, at least one of the transport units 121 may sequentially move along the second distribution path LDT2, the sixth distribution path LDT6, and the fourth distribution path LDT4. In this process, at least one of the transport units 121 may move from the transport line 12 located on a higher layer to the transport line 12 located on a lower layer.

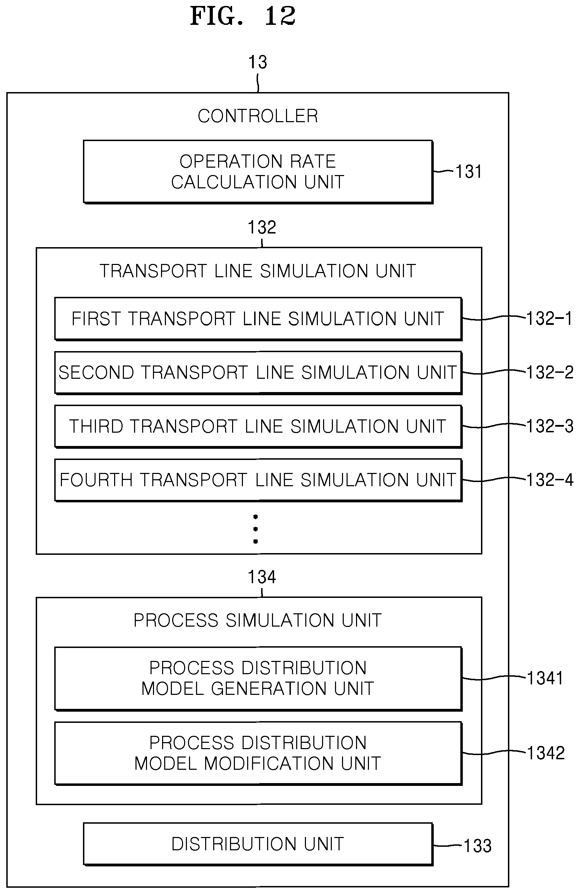

FIG. 12 is a diagram schematically illustrating a configuration of a controller 13 according to some embodiments. In FIG. 12, the same reference symbols as those of FIG. 9 denote the same member, and redundant descriptions thereof are omitted.

Compared to the embodiments described with reference to FIGS. 8 to 10, in the embodiments shown in FIG. 12, the transport line simulation unit 132 may further include a third transport line simulation unit 132-3 and a fourth transport line simulation unit 132-4.

The third transport line simulation unit 132-3 may simulate a third-order transport line distribution model for distributing the plurality of third transport units 121-3 (see FIG. 11) by calculating a number of plurality of third transport units 121-3 arranged on the third transport path LIT3 such that operation rates of the plurality of third transport units 121-3 are within a designated range. The fourth transport line simulation unit 132-4 may simulate a fourth-order transport line distribution model for distributing the plurality of fourth transport units 121-4 (see FIG. 11) by calculating a number of plurality of fourth transport units 121-4 arranged on the fourth transport path LIT4 such that operation rates of the plurality of fourth transport units 121-4 are within a designated range.

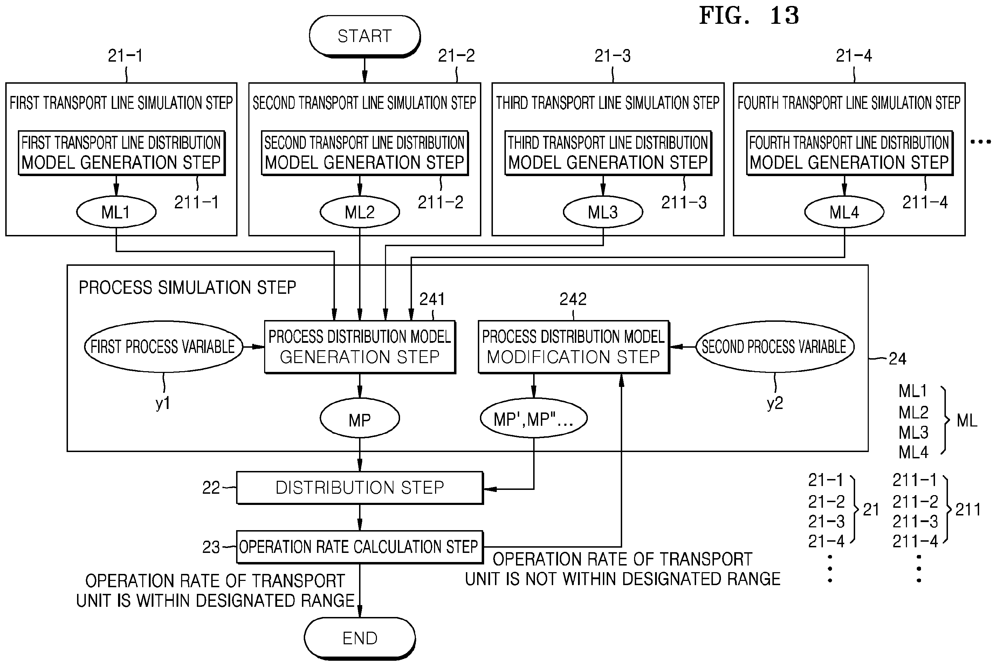

FIG. 13 is a flowchart of a method for manufacturing a display device, according to some embodiments. In FIG. 13, the same reference symbols as those of FIG. 10 denote the same member, and redundant descriptions thereof are omitted.

Compared to the embodiments described with reference to FIGS. 8 to 10, the transport line simulation step 21 of FIG. 13 may further include a third transport line simulation step 21-3 and a fourth transport line simulation step 21-4.

The third transport line simulation step 21-3 may be a step of simulating, by the third transport line simulation unit 132-3, a third transport line distribution model for distributing the plurality of third transport units 121-3 (see FIG. 11), such that operation rates of the third transport units 121-3 are within a designated range. The third transport line simulation step 21-3 may include a third transport line distribution model generation step 211-3 for generating an initial third transport line distribution model ML3.

The fourth transport line simulation step 21-4 may be a step of simulating, by the fourth transport line simulation unit 132-4, a fourth transport line distribution model for distributing the plurality of fourth transport units 121-4 (see FIG. 11), such that operation rates of the fourth transport units 121-4 are within a designated range. The fourth transport line simulation step 21-4 may include a fourth transport line distribution model generation step 211-4 for generating an initial fourth transport line distribution model ML4.

The process simulation step 24 may include a step of simulating a process distribution model for distributing the plurality of transport units 121 between the plurality of transport lines 12 (see FIG. 11) based on the initial transport line distribution model ML of each of the plurality of transport lines 12. For example, the process simulation step 24 may include a step of simulating the process distribution model for distributing the plurality of transport units 121 between the first transport line 12-1 (see FIG. 11), the second transport line 12-2 (see FIG. 11), a third transport line 12-3 (see FIG. 11), and a fourth transport line 12-4 (see FIG. 11) based on the initial first transport line distribution model ML1, the initial second transport line distribution model ML2, the initial third transport line distribution model ML3, and the initial fourth transport line distribution model ML4.

According to one or more embodiments, a plurality of transport units may be controlled such that an operation rate of each of the plurality of transport units is within a designated range, thereby improving efficiency of a transport line.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

The characteristics of embodiments according to the present disclosure are not limited to the characteristics described above, and other characteristics not mentioned will be more clearly understood by a person skilled in the art from the description of the claims.

## Claims

1. An apparatus (1) for manufacturing a display device, the apparatus (1) comprising:
a plurality of processing lines (11) comprising a plurality of processing units (111);
a transport line (12) between the plurality of processing lines (11), the transport line (12) comprising a plurality of transport units (121) configured to move along a transport path (LIT) to take in or take out transport goods (GD) to or from the plurality of processing units (111); and
a controller (13) configured to control the plurality of transport units (121),
wherein the controller (13) comprises an operation rate calculation
unit, a distribution unit and a transport line simulator (132), wherein the transport line simulator comprises a transport line distribution model generator and a transport line distribution model modification unit, wherein
the transport line distribution model generator is configured to generate an initial transport line distribution model (ML) by considering a first transport line variable;
wherein the first transport line variable includes an operation plan of the plurality of processing lines (11);
the distribution unit is configured to distribute, the plurality of transport units (121) according to the initial transport line distribution model;
the operation rate calculation unit (131) is configured to calculate an operation rate of each of the plurality of transport units;
the transport line distribution line distribution model modifier is configured to
either modify the initial transport line distribution model (ML) to a first-order modified transport line distribution model by reducing or increasing the number of transport units arranged on the transport path (LIT),
wherein reducing the number of transport units arranged on the transport path (LIT) is performed when an operation rate of at least one of the plurality of transport units is less than a designated range, and
wherein increasing the number of transport units arranged on the transport path (LIT) is performed when the operation rate of at least one of the plurality of transport units exceeds the designated range,
or modify the initial transport line distribution model to a first-order modified transport line model by considering a second transport line variable,
wherein the second transport line variable includes:
data on a collision between the plurality of transport units;
a shortage of materials necessary for the processing unit (111) to process the transport goods;
unplanned or irregular maintenance or repair of the processing unit; an operator's intervention in the processing line (11) or the transport line (12);
a communication error between at least one of the processing line, the transport line, the controller, a database, or a network;
the transport line distribution model generator is configured distribute the plurality of transport units according to the first-order modified transport line distribution model obtained through modification by the transport line distribution model modification unit,
the operation rate calculation unit is configured to calculate an operation rate of each of the plurality of transport units, and to determine whether the operation rate of at least one of the plurality of transport units calculated by the operation rate calculation unit is not within a designated range,
the controller is configured remodify the first-order modified transport line distribution model to a second-order transport line distribution model until the operation rates of all of the plurality of transport units calculated by the operation rate calculation unit fall within the designated range,
wherein the transport line distribution model are repeatedly remodified according to the same modification as the above-described modification.

2. The apparatus (1) of claim 1, wherein the operation plan includes at least one of a planned type, processing speed, number, or arrangement of the processing line (11) of the plurality of processing lines (11).

3. The apparatus (1) of claim 1, wherein at least two of the plurality of transport lines (12) are on different layers from each other.

4. The apparatus (1) of at least one of claims 1 to 3, wherein at least one of the plurality of transport units (121) is configured to move between the transport path (LIT) and a stage (STA).

5. A method of manufacturing a display apparatus (1), the method comprising:
arranging a transport line (12) comprising a plurality of transport units (121), between a plurality of transport lines (12), wherein the plurality of transport units (121), are movable along a transport path (LIT) to take in or take out transport goods (GD) to or from a plurality of processing units (111); and
simulating a transport line distribution model by considering a first transport line variable for distributing and controlling the plurality of transport units (121);
wherein the first transport line variable includes an operation plan of the plurality of processing lines (11);
wherein the distribution unit distributes the plurality of transport units (121) according to the initial transport line distribution model;
the operation rate calculation unit (131) calculates an operation rate of each of the plurality of transport units; and
wherein the transport line distribution line distribution model
either modifies the initial transport line distribution model (ML) to a first-order modified transport line distribution model by reducing or increasing the number of transport units arranged on the transport path (LIT),
wherein reducing the number of transport units arranged on the transport path (LIT) is performed when an operation rate of at least one of the plurality of transport units is less than a designated range, and
wherein increasing the number of transport units arranged on the transport path (LIT) is performed when the operation rate of at least one of the plurality of transport units exceeds the designated range,
or modifies the initial transport line distribution model to a first-order modified transport line model by considering a second transport line variable,
wherein the second transport line variable includes:
data on a collision between the plurality of transport units;
a shortage of materials necessary for the processing unit (111) to process the transport goods;
unplanned or irregular maintenance or repair of the processing unit; an operator's intervention in the processing line (11) or the transport line (12);
a communication error between at least one of the processing line, the transport line, the controller, a database, or a network;
wherein the transport line distribution model generator further distributes the plurality of transport units according to the first-order modified transport line distribution model obtained through modification by the transport line distribution model modification unit,
the operation rate calculation unit calculates an operation rate of each of the plurality of transport units, and determines whether the operation rate of at least one of the plurality of transport units calculated by the operation rate calculation unit is not within a designated range, and
wherein the controller remodifies the first-order modified transport line distribution model to a second-order transport line distribution model until the operation rates of all of the plurality of transport units calculated by the operation rate calculation unit fall within the designated range,
wherein the transport line distribution model are repeatedly remodified according to the same modification as the above-described modification.

6. The method of claim 5, further comprising simulating the process distribution model for distributing the plurality of transport units (121) between the plurality of transport lines, based on a transport line distribution model of each of the plurality of transport lines (12).

7. The method of at least one of claims 5 or 6, further comprising:
distributing the plurality of transport units (121) according to the initial process distribution model.

8. The method of claim 7, further comprising:
calculating the operation rates of the plurality of transport units (121);
based on the operation rates of the plurality of transport units (121) not being within the designated range, modifying the initial process distribution model to a first-order modified process distribution model; and
distributing the plurality of transport units (121) according to the first-order modified process distribution model.

9. The method of claim 8, further comprising, based on the operation rates of the plurality of transport units (121) not being within the designated range, remodifying the first-order modified process distribution model to a second-order modified process distribution model.

10. The method of at least one of claims 5 to 9, wherein at least two of the plurality of transport lines are on different layers from each other, and
the method further comprises moving at least one of the plurality of transport units (121) between the plurality of transport lines un(12) on the different layers from each other.

## Patentansprüche

1. Eine Vorrichtung (1) zum Herstellen einer Anzeigevorrichtung, wobei die Vorrichtung (1) umfasst:
eine Vielzahl von Verarbeitungslinien (11), umfassend eine Vielzahl von Verarbeitungseinheiten (111);
eine Transportlinie (12) zwischen der Vielzahl von Verarbeitungslinien (11), wobei die Transportlinie (12) eine Vielzahl von Transporteinheiten (121) umfasst, die dazu eingerichtet sind, sich entlang eines Transportwegs (LIT) zu bewegen, um Transportgüter (GD) in die Vielzahl von Verarbeitungseinheiten (111) hereinzunehmen nehmen oder von dieser herauszunehmen; und
eine Steuerung (13), die dazu eingerichtet ist, die Vielzahl von Transporteinheiten (121) zu steuern,
wobei die Steuerung (13) eine Betriebsratenberechnungseinheit, eine Verteilungseinheit und einen Transportlinien-Simulator (132) umfasst, wobei der Transportlinien-Simulator einen Transportlinien-Verteilungsmodellerzeuger und eine Transportlinien-Verteilungsmodellmodifikationseinheit umfasst, wobei der Transportlinien-Verteilungsmodellerzeuger dazu eingerichtet ist, ein anfängliches Transportlinien-Verteilungsmodell (ML) unter Berücksichtigung einer ersten Transportlinienvariablen zu erzeugen;
wobei die erste Transportlinienvariable einen Betriebsplan der Vielzahl von Verarbeitungslinien (11) umfasst;
die Verteilungseinheit dazu eingerichtet ist, die Vielzahl von Transporteinheiten (121) gemäß dem anfänglichen Transportlinien-Verteilungsmodell zu verteilen;
die Betriebsratenberechnungseinheit (131) dazu eingerichtet ist, eine Betriebsrate jeder der Vielzahl von Transporteinheiten zu berechnen;
der Transportlinien-Verteilungsmodellmodifizierer dazu eingerichtet ist, entweder das anfängliche Transportlinien-Verteilungsmodell (ML) zu einem Transportlinien-Verteilungsmodell erster Ordnung durch Verringern oder Erhöhen der Anzahl von auf dem Transportweg (LIT) angeordneten Transporteinheiten zu modifizieren,
wobei das Verringern der Anzahl von auf dem Transportweg (LIT) angeordneten Transporteinheiten durchgeführt wird, wenn eine Betriebsrate von mindestens einer der Vielzahl von Transporteinheiten kleiner als ein bestimmter Bereich ist, und
wobei das Erhöhen der Anzahl von auf dem Transportweg (LIT) angeordneten Transporteinheiten durchgeführt wird, wenn die Betriebsrate von mindestens einer der Vielzahl von Transporteinheiten den bestimmten Bereich überschreitet, oder das anfängliche Transportlinien-Verteilungsmodell zu einem Transportlinienmodell erster Ordnung durch Berücksichtigen einer zweiten Transportlinienvariablen zu modifizieren,
wobei die zweite Transportlinienvariable umfasst:
Daten über eine Kollision zwischen der Vielzahl von Transporteinheiten;
einen Mangel an Materialien, die für die Verarbeitungseinheit (111) notwendig sind, um die Transportgüter zu verarbeiten;
ungeplante oder unregelmäßige Wartung oder Reparatur der Verarbeitungseinheit; einen Eingriff eines Bedieners in die Verarbeitungslinie (11) oder die Transportlinie (12);
einen Kommunikationsfehler zwischen mindestens einer der Verarbeitungslinie, der Transportlinie, der Steuerung, einer Datenbank oder einem Netzwerk;
wobei der Transportlinien-Verteilungsmodellerzeuger dazu eingerichtet ist, die Vielzahl von Transporteinheiten gemäß dem Transportlinien-Verteilungsmodell erster Ordnung zu verteilen, das durch Modifikation durch die Transportlinien-Verteilungsmodellmodifikationseinheit erhalten wird,
die Betriebsratenberechnungseinheit dazu eingerichtet ist, eine Betriebsrate jeder der Vielzahl von Transporteinheiten zu berechnen und zu bestimmen, ob die von der Betriebsratenberechnungseinheit berechnete Betriebsrate von mindestens einer der Vielzahl von Transporteinheiten nicht innerhalb eines bestimmten Bereichs liegt,
die Steuerung dazu eingerichtet ist, das Transportlinien-Verteilungsmodell erster Ordnung zu einem Transportlinien-Verteilungsmodell zweiter Ordnung erneut zu modifizieren, bis die von der Betriebsratenberechnungseinheit berechneten Betriebsraten aller der Vielzahl von Transporteinheiten in den bestimmten Bereich fallen,
wobei das Transportlinien-Verteilungsmodell wiederholt gemäß derselben Modifikation wie die vorstehend beschriebene Modifikation erneut modifiziert wird.

2. Die Vorrichtung (1) nach Anspruch 1, wobei der Betriebsplan mindestens eines von einem geplanten Typ, einer Verarbeitungsgeschwindigkeit, einer Anzahl oder einer Anordnung der Verarbeitungslinie (11) der Vielzahl von Verarbeitungslinien (11) umfasst.

3. Die Vorrichtung (1) nach Anspruch 1, wobei mindestens zwei der Vielzahl von Transportlinien (12) auf unterschiedlichen Schichten voneinander angeordnet sind.

4. Die Vorrichtung (1) nach mindestens einem der Ansprüche 1 bis 3, wobei mindestens eine der Vielzahl von Transporteinheiten (121) dazu eingerichtet ist, sich zwischen dem Transportweg (LIT) und einer Stufe (STA) zu bewegen.

5. Ein Verfahren zum Herstellen einer Anzeigevorrichtung (1), wobei das Verfahren umfasst:
Anordnen einer Transportlinie (12), umfassend eine Vielzahl von Transporteinheiten (121), zwischen einer Vielzahl von Transportlinien (12), wobei die Vielzahl von Transporteinheiten (121) entlang eines Transportwegs (LIT) bewegbar ist, um Transportgüter (GD) in eine Vielzahl von Verarbeitungseinheiten (111) hereinzunehmen oder aus dieser herauszunehmen; und
Simulieren eines Transportlinien-Verteilungsmodells unter Berücksichtigung einer ersten Transportlinienvariablen zum Verteilen und Steuern der Vielzahl von Transporteinheiten (121);
wobei die erste Transportlinienvariable einen Betriebsplan der Vielzahl von Verarbeitungslinien (11) umfasst;
wobei die Verteilungseinheit die Vielzahl von Transporteinheiten (121) gemäß dem anfänglichen Transportlinien-Verteilungsmodell verteilt;
die Betriebsratenberechnungseinheit (131) eine Betriebsrate jeder der Vielzahl von Transporteinheiten berechnet; und
wobei die Transportlinien-Verteilungsmodell-Verteilungseinheit entweder das anfängliche Transportlinien-Verteilungsmodell (ML) zu einem Transportlinien-Verteilungsmodell erster Ordnung durch Verringern oder Erhöhen der Anzahl von auf dem Transportweg (LIT) angeordneten Transporteinheiten modifiziert,
wobei das Verringern der Anzahl von auf dem Transportweg (LIT) angeordneten Transporteinheiten durchgeführt wird, wenn eine Betriebsrate von mindestens einer der Vielzahl von Transporteinheiten kleiner als ein bestimmter Bereich ist, und
wobei das Erhöhen der Anzahl von auf dem Transportweg (LIT) angeordneten Transporteinheiten durchgeführt wird, wenn die Betriebsrate von mindestens einer der Vielzahl von Transporteinheiten den bestimmten Bereich überschreitet, oder das anfängliche Transportlinien-Verteilungsmodell zu einem Transportlinienmodell erster Ordnung durch Berücksichtigen einer zweiten Transportlinienvariablen modifiziert,
wobei die zweite Transportlinienvariable umfasst:
Daten über eine Kollision zwischen der Vielzahl von Transporteinheiten;
einen Mangel an Materialien, die für die Verarbeitungseinheit (111) notwendig sind, um die Transportgüter zu verarbeiten;
ungeplante oder unregelmäßige Wartung oder Reparatur der Verarbeitungseinheit; einen Eingriff eines Bedieners in die Verarbeitungslinie (11) oder die Transportlinie (12); einen Kommunikationsfehler zwischen mindestens einer der Verarbeitungslinie, der Transportlinie, der Steuerung, einer Datenbank oder einem Netzwerk, wobei der Transportlinien-Verteilungsmodellerzeuger ferner die Vielzahl von Transporteinheiten gemäß dem Transportlinien-Verteilungsmodell erster Ordnung verteilt, das durch Modifikation durch die Transportlinien-Verteilungsmodellmodifikationseinheit erhalten wird,
die Betriebsratenberechnungseinheit eine Betriebsrate jeder der Vielzahl von Transporteinheiten berechnet und bestimmt, ob die von der Betriebsratenberechnungseinheit berechnete Betriebsrate von mindestens einer der Vielzahl von Transporteinheiten nicht innerhalb eines bestimmten Bereichs liegt, und
wobei die Steuerung das Transportlinien-Verteilungsmodell erster Ordnung zu einem Transportlinien-Verteilungsmodell zweiter Ordnung erneut modifiziert, bis die von der Betriebsratenberechnungseinheit berechneten Betriebsraten aller der Vielzahl von Transporteinheiten in den bestimmten Bereich fällt,
wobei das Transportlinien-Verteilungsmodell wiederholt gemäß derselben Modifikation wie die vorstehend beschriebene Modifikation erneut modifiziert wird.

6. Das Verfahren nach Anspruch 5, ferner umfassend das Simulieren des Prozessverteilungsmodells zum Verteilen der Vielzahl von Transporteinheiten (121) zwischen der Vielzahl von Transportlinien auf Grundlage eines Transportlinien-Verteilungsmodells jeder der Vielzahl von Transportlinien (12).

7. Das Verfahren nach mindestens einem der Ansprüche 5 oder 6, ferner umfassend:
Verteilen der Vielzahl von Transporteinheiten (121) gemäß dem anfänglichen Prozessverteilungsmodell.

8. Das Verfahren nach Anspruch 7, ferner umfassend:
Berechnen der Betriebsraten der Vielzahl von Transporteinheiten (121);
auf Grundlage dessen, dass die Betriebsraten der Vielzahl von Transporteinheiten (121) nicht innerhalb des bestimmten Bereichs liegen, Modifizieren des anfänglichen Prozessverteilungsmodells zu einem Prozessverteilungsmodell erster Ordnung; und
Verteilen der Vielzahl von Transporteinheiten (121) gemäß dem Prozessverteilungsmodell erster Ordnung.

9. Das Verfahren nach Anspruch 8, ferner umfassend, auf Grundlage dessen, dass die Betriebsraten der Vielzahl von Transporteinheiten (121) nicht innerhalb des bestimmten Bereichs liegen, erneutes Modifizieren des Prozessverteilungsmodells erster Ordnung zu einem Prozessverteilungsmodell zweiter Ordnung.

10. Das Verfahren nach mindestens einem der Ansprüche 5 bis 9, wobei mindestens zwei der Vielzahl von Transportlinien auf unterschiedlichen Schichten voneinander angeordnet sind, und
wobei das Verfahren ferner das Bewegen mindestens einer der Vielzahl von Transporteinheiten (121) zwischen der Vielzahl von Transportlinien (12) auf den unterschiedlichen Schichten voneinander umfasst.

## Revendications

1. Appareil (1) de fabrication d'un dispositif d'affichage, l'appareil (1) comprenant :
une pluralité de lignes de traitement (11) comprenant une pluralité d'unités de traitement (111) ;
une ligne de transport (12) entre la pluralité de lignes de traitement (11), la ligne de transport (12) comprenant une pluralité d'unités de transport (121) configurées pour se déplacer le long d'un trajet de transport (LIT) pour mettre ou retirer des marchandises de transport (GD) dans ou hors de la pluralité d'unités de traitement (111) ; et
une unité de commande (13) configurée pour commander la pluralité d'unités de transport (121),
dans lequel l'unité de commande (13) comprend une unité de calcul de débit de fonctionnement, une unité de distribution et un simulateur de ligne de transport (132), dans lequel le simulateur de ligne de transport comprend un générateur de modèle de distribution de lignes de transport et une unité de modification de modèle de distribution de lignes de transport, dans lequel le générateur de modèle de distribution de lignes de transport est configuré pour générer un modèle de distribution de lignes de transport initial (ML) en considérant une première variable de ligne de transport ;
dans lequel la première variable de ligne de transport comporte un plan de fonctionnement de la pluralité de lignes de traitement (11) ;
l'unité de distribution est configurée pour distribuer la pluralité d'unité de transport (121) selon le modèle de distribution de lignes de transport initial ;
l'unité de calcul de débit de fonctionnement (131) est configurée pour calculer un débit de fonctionnement de chacune de la pluralité d'unités de transport ;
le modificateur de modèle de distribution de ligne de distribution de lignes de transport est configuré pour
soit modifier le modèle de distribution de lignes de transport initial (ML) en un modèle de distribution de lignes de transport modifié de premier ordre en réduisant ou en augmentant le nombre d'unités de transport agencées sur le trajet de transport (LIT),
dans lequel la réduction du nombre d'unités de transport agencées sur le trajet de transport (LIT) est effectuée lorsqu'un débit de fonctionnement d'au moins l'une parmi la pluralité d'unités de transport est en-dessous d'une plage désignée, et
dans lequel l'augmentation du nombre d'unités de transport agencées sur le trajet de transport (LIT) est effectuée lorsque le débit de fonctionnement d'au moins l'une parmi la pluralité d'unités de transport dépasse la plage désignée,
ou modifier le modèle de distribution de lignes de transport initial en un modèle de ligne de transport modifié de premier ordre en considérant une deuxième variable de ligne de transport,
dans lequel la deuxième variable de ligne de transport comporte :
des données concernant une collision entre la pluralité d'unités de transport ;
un manque de matériaux nécessaires à l'unité de traitement (111) pour traiter les marchandises de transport ;
une maintenance ou une réparation non-planifiée ou irrégulière de l'unité de traitement ; une intervention d'un opérateur dans la ligne de traitement (11) ou la ligne de transport (12) ;
une erreur de communication entre au moins l'une parmi la ligne de traitement, la ligne de transport, l'unité de commande, une base de données, ou un réseau ;
le générateur de modèle de distribution de lignes de transport est configuré pour distribuer la pluralité d'unités de transport selon le modèle de distribution de lignes de transport modifié de premier ordre obtenu par modification par l'unité de modification de modèle de distribution de lignes de transport,
l'unité de calcul de débit de fonctionnement est configurée pour calculer un débit de fonctionnement de chacune de la pluralité d'unités de transport, et pour déterminer si le débit de fonctionnement d'au moins l'une parmi la pluralité d'unités de transport calculé par l'unité de calcul de débit de fonctionnement n'est pas dans une plage désignée,
l'unité de commande est configurée pour remodifier le modèle de distribution de lignes de transport modifié de premier ordre en un modèle de distribution de lignes de transport de deuxième ordre jusqu'à ce que les débits de fonctionnement de toutes les unités de transport de la pluralité d'unités de transport calculés par l'unité de calcul de débit de fonctionnement descendent dans la plage désignée,
dans lequel le modèle de distribution de lignes de transport est remodifié de manière répétitive selon la même modification que la modification décrite ci-dessus.

2. Appareil (1) selon la revendication 1, dans lequel le plan de fonctionnement comporte au moins l'un parmi un type, une vitesse de traitement, un nombre, ou un agencement planifié(s) de la ligne de traitement (11) parmi la pluralité de lignes de traitement (11).

3. Appareil (1) selon la revendication 1, dans lequel au moins deux parmi la pluralité de lignes de transport (12) se trouvent sur des couches différentes les unes des autres.

4. Appareil (1) selon au moins l'une des revendications 1 à 3, dans lequel au moins l'une parmi la pluralité d'unités de transport (121) est configurée pour se déplacer entre le trajet de transport (LIT) et un étage (STA).

5. Procédé de fabrication d'un appareil d'affichage (1), le procédé comprenant :
l'agencement d'une ligne de transport (12) comprenant une pluralité d'unités de transport (121), entre une pluralité de lignes de transport (12), dans lequel la pluralité d'unités de transport (121) peut se déplacer le long d'un trajet de transport (LIT) pour mettre ou retirer des marchandises de transport (GD) dans ou hors d'une pluralité d'unités de traitement (111) ; et
la simulation d'un modèle de distribution de lignes de transport en considérant une première variable de ligne de transport pour la distribution et la commande de la pluralité d'unités de transport (121) ;
dans lequel la première variable de ligne de transport comporte un plan de fonctionnement de la pluralité de lignes de traitement (11) ;
dans lequel l'unité de distribution distribue la pluralité d'unité de transport (121) selon le modèle de distribution de lignes de transport initial ;
l'unité de calcul de débit de fonctionnement (131) calcule un débit de fonctionnement de chacune de la pluralité d'unités de transport ; et
dans lequel le modèle de distribution de ligne de distribution de lignes de transport
soit modifie le modèle de distribution de lignes de transport initial (ML) en un modèle de distribution de lignes de transport modifié de premier ordre en réduisant ou en augmentant le nombre d'unités de transport agencées sur le trajet de transport (LIT),
dans lequel la réduction du nombre d'unités de transport agencées sur le trajet de transport (LIT) est effectuée lorsqu'un débit de fonctionnement d'au moins l'une parmi la pluralité d'unités de transport est en-dessous d'une plage désignée, et
dans lequel l'augmentation du nombre d'unités de transport agencées sur le trajet de transport (LIT) est effectuée lorsque le débit de fonctionnement d'au moins l'une parmi la pluralité d'unités de transport dépasse la plage désignée,
ou modifie le modèle de distribution de lignes de transport initial en un modèle de ligne de transport modifié de premier ordre en considérant une deuxième variable de ligne de transport,
dans lequel la deuxième variable de ligne de transport comporte :
des données concernant une collision entre la pluralité d'unités de transport ;
un manque de matériaux nécessaires à l'unité de traitement (111) pour traiter les marchandises de transport ;
une maintenance ou une réparation non-planifiée ou irrégulière de l'unité de traitement ; une intervention d'un opérateur dans la ligne de traitement (11) ou la ligne de transport (12) ;
une erreur de communication entre au moins l'une parmi la ligne de traitement, la ligne de transport, l'unité de commande, une base de données, ou un réseau ;
dans lequel le générateur de modèle de distribution de lignes de transport distribue en outre la pluralité d'unités de transport selon le modèle de distribution de lignes de transport modifié de premier ordre obtenu par modification par l'unité de modification de modèle de distribution de lignes de transport,
l'unité de calcul de débit de fonctionnement calcule un débit de fonctionnement de chacune de la pluralité d'unités de transport, et détermine si le débit de fonctionnement d'au moins l'une parmi la pluralité d'unités de transport calculé par l'unité de calcul de débit de fonctionnement n'est pas dans une plage désignée, et
dans lequel l'unité de commande remodifie le modèle de distribution de lignes de transport modifié de premier ordre en un modèle de distribution de lignes de transport de deuxième ordre jusqu'à ce que les débits de fonctionnement de toutes les unités de transport de la pluralité d'unités de transport calculés par l'unité de calcul de débit de fonctionnement descendent dans la plage désignée, dans lequel le modèle de distribution de lignes de transport est remodifié de manière répétitive selon la même modification que la modification décrite ci-dessus.

6. Procédé selon la revendication 5, comprenant en outre la simulation du modèle de distribution de traitements pour la distribution de la pluralité d'unités de transport (121) entre la pluralité de lignes de transport, sur la base d'un modèle de distribution de lignes de transport de chacune de la pluralité de lignes de transport (12).

7. Procédé selon au moins l'une des revendications 5 ou 6, comprenant en outre :
la distribution de la pluralité d'unités de transport (121) selon le modèle de distribution de traitements initial.

8. Procédé selon la revendication 7, comprenant en outre :
le calcul des débits de fonctionnement de la pluralité d'unités de transport (121) ;
sur la base des débits de fonctionnement de la pluralité d'unités de transport (121) qui ne se trouvent pas dans la plage désignée, la modification du modèle de distribution de traitements initial en un modèle de distribution de traitements modifié de premier ordre ; et
la distribution de la pluralité d'unités de transport (121) selon le modèle de distribution de traitements modifié de premier ordre.

9. Procédé selon la revendication 8, comprenant en outre, sur la base des débits de fonctionnement de la pluralité d'unités de transport (121) qui ne se trouvent pas dans la plage désignée, la remodification du modèle de distribution de traitements modifié de premier ordre en un modèle de distribution de traitements modifié de deuxième ordre.

10. Procédé selon au moins l'une des revendications 5 à 9, dans lequel au moins deux parmi la pluralité de lignes de transport se trouvent sur des couches différentes les unes des autres, et
le procédé comprend en outre le déplacement d'au moins l'une parmi la pluralité d'unités de transport (121) entre la pluralité de lignes de transport (12) sur les couches différentes les unes des autres.
